# EUROPEAN PATENT SPECIFICATION

(11) **EP 3 491 555 B1**
(45) Date of publication and mention of the grant of the patent: **20.03.2024**
(21) Application number: 16744748.1
(22) Date of filing: 27.07.2016
(51) Int. Cl.: G06F 30/39

(54) **APPARATUS AND METHOD FOR GENERATING SERIAL MOS ELEMENTS AND APPARATUS AND METHOD FOR GENERATING A CIRCUIT LAYOUT FROM A MOS TRANSISTOR CIRCUIT SCHEMATIC**
VORRICHTUNG UND VERFAHREN ZUR ERZEUGUNG VON SERIELLEN MOS-ELEMENTEN UND VORRICHTUNG UND VERFAHREN ZUR ERZEUGUNG EINER SCHALTUNGSANORDNUNG AUS EINEM MOS-TRANSISTORSCHALTSCHEMA
APPAREIL ET PROCÉDÉ POUR GÉNÉRER DES ÉLÉMENTS MOS EN SÉRIE ET APPAREIL ET PROCÉDÉ POUR GÉNÉRER UN AGENCEMENT DE CIRCUITS À PARTIR D'UN SCHÉMA DE CIRCUIT DE TRANSISTOR MOS

(43) Date of publication of application: 05.06.2019
(73) Proprietor: Fraunhofer-Gesellschaft zur Förderung der angewandten Forschung e.V., 80686 München (DE)
(72) Inventor: HERZER, Elmar, 91052 Erlangen (DE); VOELKER, Matthias, 91054 Erlangen (DE)
(74) Representative: Hersina, Günter
(86) International application number: PCT/EP2016/067938
(87) International publication number: WO 2018/019371

(56) References cited:
- US-A1- 2015 331 985
- US-B1- 7 418 683
- BO YANG ET AL: "Structured Analog Circuit and Layout Design with Transistor Array", IEICE TRANSACTIONS ON FUNDAMENTALS OF ELECTRONICS,COMMUNICATIONS AND COMPUTER SCIENCES, ENGINEERING SCIENCES SOCIETY, TOKYO, JP, vol. E96A, no. 12, 1 December 2013 (2013-12-01), pages 2475-2486, XP001586642, ISSN: 0916-8508, DOI: 10.1587/TRANSFUN.E96.A.2475

## Description

This disclosure relates to an apparatus and a method for generating serial MOS elements and a further apparatus and a further method for building a circuit layout from a MOS transistor circuit schematic. Embodiments relate to a serial MOS data structure and method. Thus, new clustering of transistor fingers in schematic may enable fully automated generation of perfect analog module layouts.

Circuits are commonly drawn as schematic with connected pins and devices. From this circuit representation the circuit's layout is derived partly manually and partly by automated procedure. "Creating a layout" is finding a solution in solving the schematic to layout mapping problem.

Basically, the problem to generate layouts from schematic is a database operation. The abstract model of electrically connected devices with pin connections is mapped to a geometrical representation which is the plan how to manufacture physical structures on chip.

To be able to do this mapping, additional data is created: The layouter's expertise adds properties to the circuit, like symmetry, to share Drain/Source regions or not etc. So there is additional data to be stored somewhere, preferably only once, if data is common for multiple objects.

The traditional way is to draw the schematic from connected transistors. Then, for each of the transistors, one or more layout instances are created in layout view which have to be modified in shape (e.g. for shared regions), arranged and connected in the graphical post process "layout creation".

For this the two circuit representations "schematic" and "layout" correspond to each other but have only partly common properties to ease the schematic to layout mapping problem. The mapping of a schematic device with net connectivity to the corresponding layout devices may be realized as an 1:N database relation in current CAD environments. Information needed to post processing the layout properly are sometimes stored with the devices (as properties), in a connected database structure (physical constraint database) or in most cases in the layouter's brain.

Thus, deriving circuit layouts from circuit schematics is a time consuming process and further relates mainly to the experience of the layouter (e.g. engineer).

US 2015/331985 A1 relates to an area optimized driver layout. The computerized method for designing a layout of a driver includes analyzing a schematic circuit. PMOSFETs coupled between first common nodes are grouped into one or more first classes. NMOSFETs coupled between second common nodes are grouped into one or more second classes. The method further includes generating the layout for each MOSFET at each location in a layout area of the driver by generating a super parameterized cell (PCELL) layout block comprising a master MOSFET PCELL and a master guard ring PCELL for each of the first class and the second class. The master MOSFET PCELL includes a first set of parameters for the MOSFET and the master guard ring PCELL includes a second set of parameters for the guard ring around the MOSFET. A child PCELL of the master MOSFET PCELL and the master guard ring PCELL are instantiated at each location in the layout area.

Therefore, there is a need for an improved approach.

It is an object of the present invention to provide an improved concept to form circuit schematics to reduce the effort of generating the layout from the schematic. This object is solved by the subject matter of the independent claims.

Embodiments show an apparatus for generating serial MOS elements comprising a transistor functional unit provider and a serial MOS element generator. The transistor functional unit provider is configured for providing a set of transistor functional units, wherein each transistor functional unit of the set of transistor functional units comprises one transistor finger or a plurality of serially connected transistor fingers having connected gates. The serial MOS element generator is configured for generating at least one serial MOS element by providing at least two serially connected transistor functional units, wherein at least one layout parameter of the at least two transistor functional units is inherited from the serial MOS element.

The present invention is based on the finding that a circuit schematic drawn using serial MOS elements is automatically convertible into a circuit layout. Each serial MOS element may be formed by (transistor functional units in lower levels of object hierarchy) transistor functional units in such a way that instances of each serial MOS element are directly abuttable. Directly abuttable serial MOS elements may therefore be arranged in the circuit layout regardless of any minimum distance between serial MOS elements, such as drain or source areas or metal layer, in different layers or any other layout parameter that would usually require to maintain a certain distance between elements of the circuit layout. In other words, serial MOS elements, or more precisely instances of serial MOS elements, may be applied adjacent or neighboring each other without a certain space between the serial MOS elements. Therefore, the directly abutted instances of serial MOS elements may be electrically connected by forming joint diffusion areas by directly abutting them such as, for example, forming a joint doping area representing a drain or a source connection of a (field effect) transistor. When layers are not considered to be connected, they are formed in such a way that correct spacing to the neighboring serial MOS element's layers is ensured.

According to embodiments, the serial MOS element generator is configured to generate the at least two serially connected transistor functional units by directly abutting drain or source areas of the serially connected transistor functional units. Directly abutting may refer to using the same or adjacent (i.e. touching) doping regions as a common or combined drain or source area for the respective adjacent transistor fingers. This structure of the transistor functional units may save space in the resulting circuit layout, since the size of the serial MOS elements comprising the transistor functional units becomes smaller. However, directly abutting may also refer to using a further electrical connection, for example by using a straight or a rectangular (metal) wire.

Further embodiments show the apparatus with the serial MOS element generator configured for generating the at least one serial MOS element using analyzing a transistor basic circuit and identifying structures of the transistor basic circuit to form the at least one serial MOS element based on the smallest identified series of transistor functional units of the basic transistor circuit. Thus, an existing circuit which is not obviously conform with the serial MOS structure or does not comprise serial MOS elements may be analyzed regarding existing transistor functional units. Thus, based on the existing transistor functional units at least one serial MOS element may be generated from the transistor functional units enabling a redrawing of the transistor basic circuit using (only) serial MOS elements (or, more precisely, instances of serial MOS elements), wherein the redrawn transistor circuit using serial MOS elements comprises the same functionality when compared to the transistor basic circuit without serial MOS elements.

According to further embodiments, an apparatus for building a circuit layout from a MOS transistor circuit schematic is shown. The apparatus may comprise a serial MOS element provider, a circuit builder and a translator. The serial MOS element provider is configured for providing a set of serial MOS elements, wherein each serial MOS element comprises at least two serially connected transistor functional units, wherein the at least one serial MOS element inherits a layout parameter to the at least two serially connected transistor functional units. The circuit builder may be configured for building the MOS transistor circuit schematic using one or multiple instances of the at least one serial MOS element. Furthermore, wherein the circuit builder may be further configured for building the MOS transistor circuit schematic based on the layout parameters of each instance of the multiple instances of the at least one serial MOS element. The translator may be configured for translating the MOS transistor circuit schematic into the circuit layout using the serial MOS element layout.

The above described embodiment refers to the actual circuit layout generator that is configured to translate a (serial) MOS transistor circuit schematic into a circuit layout for performing the implementation of the circuit schematic into, for example, a semiconductor, glass or diamond substrate for manufacturing. According to embodiments, the serial MOS element provider may be the earlier described apparatus for generating serial MOS elements.

Before embodiments are described in detail using the accompanying figures, it is to be pointed out that the same or functionally equal elements are given the same reference numbers in the figures and that a repeated description for elements provided with the same reference numbers is omitted. Hence, descriptions provided for elements having the same reference numbers are mutually exchangeable.

Embodiments of the present invention will be discussed subsequently referring to the enclosed drawings, wherein:
- Fig. 1: shows a schematic circuit diagram of a long transistor made from multiple serial devices in deep submicron CMOS processes;
- Fig. 2: shows a schematic circuit diagram of a long and wide transistor made from multiple serial devices in parallel and deep submicron CMOS processes;
- Fig. 3: shows a completion series of schematic layouts of a present circuit diagram according to a possible manual method;
- Fig. 4: shows the layout completion process of Fig. 3 using a possible software tool assisted and constrained driven method instead of the possible manual method;
- Fig. 5: shows a schematic block diagram of an apparatus for generating serial MOS elements to enable automatic layout generation,
- Fig. 6: shows a schematic block diagram of an apparatus for building a circuit layout from a MOS transistor circuit schematic;
- Fig. 7: shows a schematic circuit diagram of multiple serial devices exemplary arranged to build a current mirror circuit;
- Fig. 8: shows a schematic sequence of circuit diagrams of a differential pair transferred into a serial configuration;
- Fig. 9: shows a schematic block diagram of the differential pair device in a common centroid configuration built from four serial MOS in four orientations;
- Fig. 10: shows a schematic serial MOS layout to build the common centroid layout of Fig. 9 of the input pair circuit, wherein underlying the schematic layout the circuit diagram of Fig. 9 is drawn;
- Fig. 11: shows a schematic layout of a differential pair device in common centroid configuration built from four serial MOS in four different orientations, again underlying with the schematic circuit diagram of Fig. 9;
- Fig. 12: shows a schematic sequence of circuit layouts based on a reference transistor circuit diagram using serial MOS elements and therefore differing from Fig. 3 and Fig. 4;
- Fig. 13: shows a schematic switched mirror schematic as drawn by a schematic design engineer;
- Fig. 14: shows the switched mirror layout corresponding to Fig. 13 as drawn by layout design engineers;
- Fig. 15: shows the switched mirror schematic of Fig. 13 with all transistor fingers expanded;
- Fig. 16: shows the schematic circuit to layout MOS transistor finger correspondence using Fig. 14 and Fig. 15;
- Fig. 17: shows the schematic layout of the row of three serial MOS submodules placed in Fig. 16;
- Fig. 18a: shows a schematic and exemplary layout of a serial MOS submodule;
- Fig. 18b: shows the exemplary schematic layout of a serial MOS submodule of Fig. 18a with a reduced number of different layers, namely from the diffusion layer to the first metallization layer;
- Fig. 18c: shows the exemplary schematic layout of a serial MOS submodule of Fig. 18a with a reduced number of different layers, namely from the first metallization layer to the third metallization layer;
- Fig. 18d: shows the exemplary schematic layout of a serial MOS submodule of Fig. 18a with a reduced number of different layers, namely from third metallization layer to the fifth metallization layer;
- Fig. 18e: shows the schematic layout of a serial MOS submodule of Fig. 18a as an exploded view;
- Fig. 19: shows a schematic circuit diagram of a layout structure rearranging and grouping MOS transistor fingers from U-shape order in an array;
- Fig. 20: shows the schematic circuit diagram of Fig. 13 or Fig. 19 grouping MOS transistor fingers from an array in horizontal order as it is performed in a possible method according to Fig. 3 or Fig. 4;
- Fig. 21: shows a schematic circuit diagram which can easily be drawn by means of identical serial MOS modules (i.e. serial MOS elements);
- Fig. 22: shows a schematic circuit diagram of the serial MOS module of Fig. 21 on transistor functional unit level;
- Fig. 23: shows a schematic block diagram of a method for generating serial MOS elements;
- Fig. 24: shows a schematic block diagram of a method for building a circuit layout from a MOS transistor circuit schematic.

In the following, embodiments of the invention will be described in further detail. Elements shown in the respective figures having the same or a similar functionality will have associated therewith the same reference signs.

Clustering or grouping of devices may traditionally be done in different ways, which is a high hurdle for the mapping process.

Especially analog precision MOS transistor modules mostly consist of a plurality of serial connected transistors.

In most cases there are one or two transistors functional units in serial connection, but there are also circuits with three serial units. Circuits with four and more serial units are rarely seen but not impossible in some cases.

In ultra deep submicron CMOS bulk technologies it is difficult or may be even not possible to stack more than one threshold voltage element over the other because of low supply voltages so one would expect no serial connected devices any more.

But it is difficult or may be even not allowed to use long transistors so designer has to connect several transistor fingers in series on drain/source, connected in parallel at the gate to replace one functional single transistor finger in analog precision circuits. When technology usage goes further to FinFET (Fin Field Effect Transistor), single device length is fixed by technology and for analog circuits, the length parameter is replaced by the multiplicity of serial connected fingers. Therefore, even more serial configurations are to be expected there.

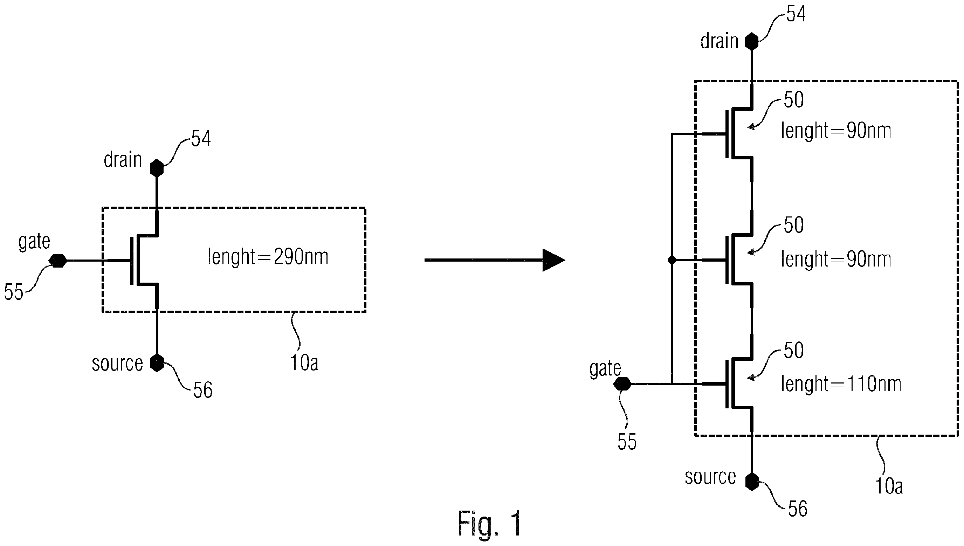

In the example shown in Fig. 1 the long transistor is the transistor functional unit 10a (from the circuit designer's view) which is built from a series of shorter transistors.

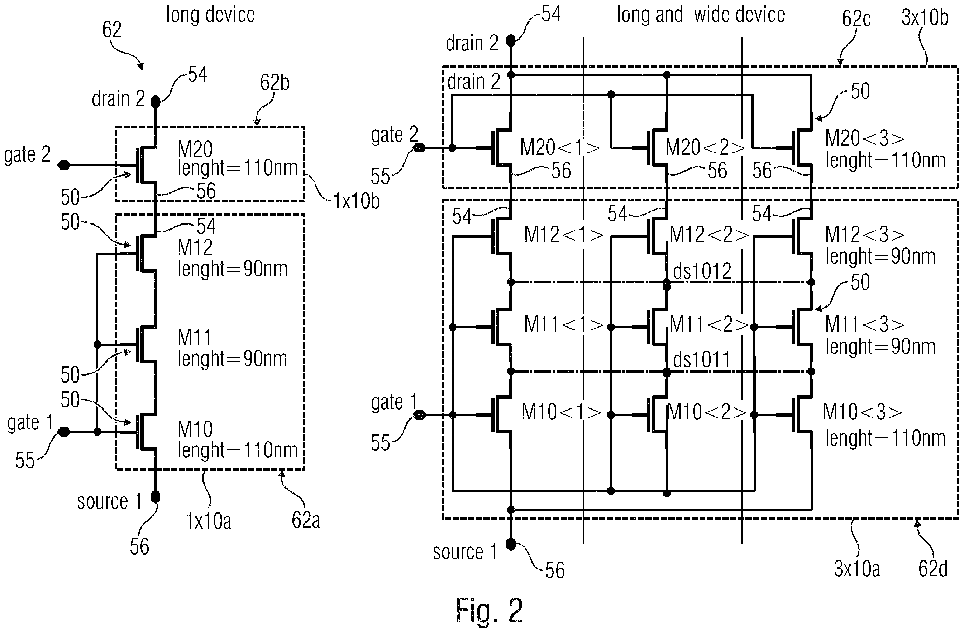

Furthermore the design rules may not allow large widths that are needed for high precision or low noise circuits because of latchup or manufacturing reasons so the transistor functional unit should be split into parallel parts composed from a series of transistors again. This means that a simple but long and wide transistor in schematic (for high analog performance) should be realized in layout by multiplicity of serial transistors, as shown e.g. in Fig. 2.

Fig. 2 shows on the left side a reasonable sized transistor M20 62b connected to a long transistor 62a composed from a series of M10, M11 and M12, all of reasonable width, because a transistor with the length of 210 nm is not allowed or at least not well modeled.

Furthermore, Fig. 2 shows on the right side where wide devices are needed while width is also limited, a circuit where the upper transistor 62c is intended to be composed from three parallel fingers 50 (in this case each transistor finger also represents a transistor functional unit) and the lower transistor 62d from 3 x 3 fingers 50 (or three parallel transistor functional units 10a).

Obviously "the transistor" is not an exact term any more. For clearer expression we distinguish the dashed boxes for the whole functional device as "transistor functional unit" 10a, 10b from the "devices" 62 and the smallest unit parts "single transistor finger" 50.

From now on in this document, the further serial decomposition of a transistor is assumed to be a step that can be done for any of the circuits without the need to be further mentioned. We assume that any "device" 62 can be subdivided into more sub "single transistor fingers" 50 in serial configuration on drain/source 54/56 side, all of them connected in parallel at the gate side 55 as described above in Fig. 1 or Fig. 2.

The smallest circuit units in the following description are the devices then.

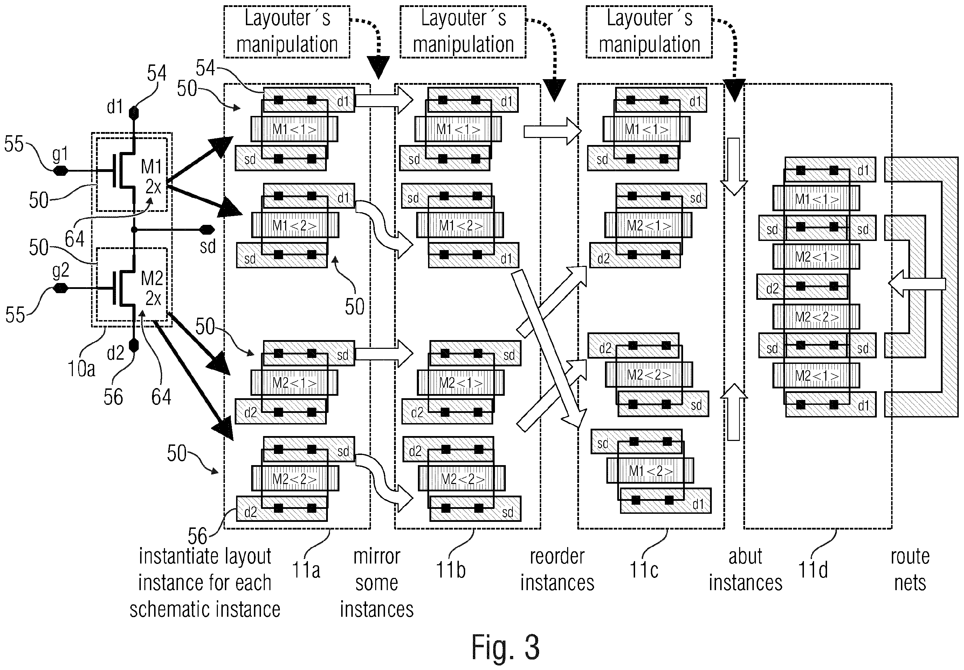

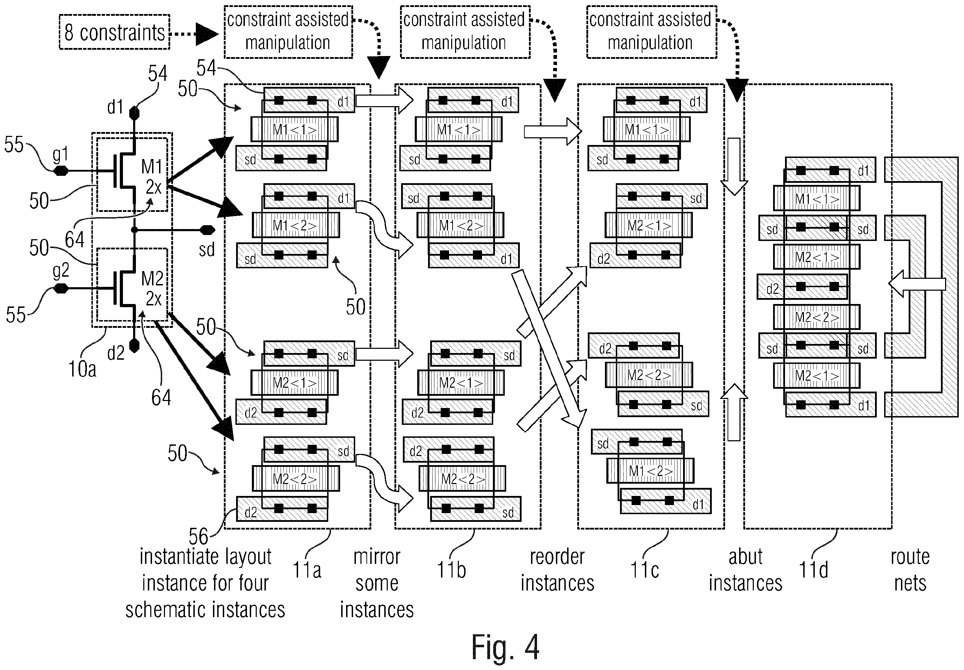

Common potential flat workflow may be:
- in schematic, the multiplicity of transistors (or transistor functional units) and fingers per transistors is represented by iterated instances and multiplicity properties 64.
- To be able to interdigitate fingers of different transistors for layout, this clustered multiplicity information is flattened and for each finger of each transistor in schematic there is an instance of a transistor with a single finger instantiated in layout (see Fig. 3, incomplete layout 11a).
- Layout instance properties experience fine tuning that the layouts of the single instances become perfect and that they can be combined.
- Elaborate placement is needed to rearrange the array using rotation, reordering and abutment (see Fig. 3, incomplete layouts 11b and 11c).
- If highly symmetrical and repetitive structure is desired, high manual effort (Fig. 3, intermediate results 11a to 11d) or complex algorithms (Fig. 4, intermediate results 11a to 11d) have to ensure its correctness for all the devices multiple times.
- Then routing finishes the module.

Hierarchical approaches divide the levels of hierarchy into primitive building blocks building circuits to build more complex circuits and so on seen from bottom up. Blocks are for example current mirrors, input pairs, etc. In some cases the blocks are named primitives because they are the smallest units of an analog circuit as shown in chapters 3.2 and 4.3 of [1, 1992]. However, for layout, primitives are always elements like transistors/transistor functional units. Between blocks and primitives, there is traditionally no further level of hierarchy in schematic. There is no change in method since 1992 until now. As an example, a current paper [2, 2014] describes basically the same method.

US 8,667,444, published March 2014, as another example, shows the object of an abutted row created from single transistor elements. Also in this publication, there is no subdivision of the rows into more complex repeated regular structures than a single transistor even though there is recognition of subsets of devices named groups. The large number of different flat combinations of transistor's arrangements with or without shared pins and wirings creates a problem of large complexity.

To solve this interactively with the designer, it needs complex tools for example as presented in the US 7,543,262 published June 2009. To solve this automatically it needs a large number of constraints. Large numbers of constraints are difficult to generate, to verify and can lead to problems without solution. As an example [3] shows algorithms to implement stacked transistor layouts from schematic on based on transistor fingers as primitive elements.

There are some approaches where they even go into drawn layer rectangle design like in US 6,351,841 from Feb. 2002. But for analog blocks, regularity is essential for accurate circuit behavior and this approach increases the number of degrees of freedom versus infinity.

Following is described an analysis of the traditional data structures and the traditional data structure's properties:
When mapping the schematic of a precision MOS transistor module to its layout, it can be observed that the smallest unit element of the module
- that defines the correspondence between schematic and layout elements is one of the fingers of a single transistor;
- that is commonly drawn in schematic once or in multiple instances is a transistor or a transistor array, each having one or more fingers as an attribute;
- that is commonly drawn in layout is a series of fingers of one or different transistors.

Obviously, hierarchical structure of the problem in schematic and layout differ.

In addition to this, the data provided in the schematics transistor instance's properties is not enough to generate a good layout because first, there is no information about the way how the transistors should be arranged and second, how the connections between the transistor device's terminals should be created. In particular, on which layer with which kind of shape or via or contact and so on.

When layouts should be created automatically from schematics we need
- mapping of the object structures; and
- objects and properties to store design intend beyond single transistor's interior properties.

Therefore, a different approach is needed to rearrange schematic data to hold the complete information needed for the mapping in an efficient way.

When clustering transistor fingers in schematic as described with respect to the following apparatuses and methods, it is possible to derive a perfect layout for the circuit automatically. This automatic layout generation may as good as the manual layout design or be even better when compared to a manual layout design, at least if human errors are taken into account. After the clusters are laid out there is only a place and route procedure left to generate complex module layouts. This enables perfect analog layout synthesis.

Embodiments describe a new data structure and a method and apparatuses using it to compose schematics and to create layouts from schematic. This apparatus or method describes the way how to structure schematic data to fit best for generating layouts and the way how to generate layouts from this schematic data.

The described apparatuses and methods not only work for MOS transistor circuits but can also be applied to other abuttable devices.

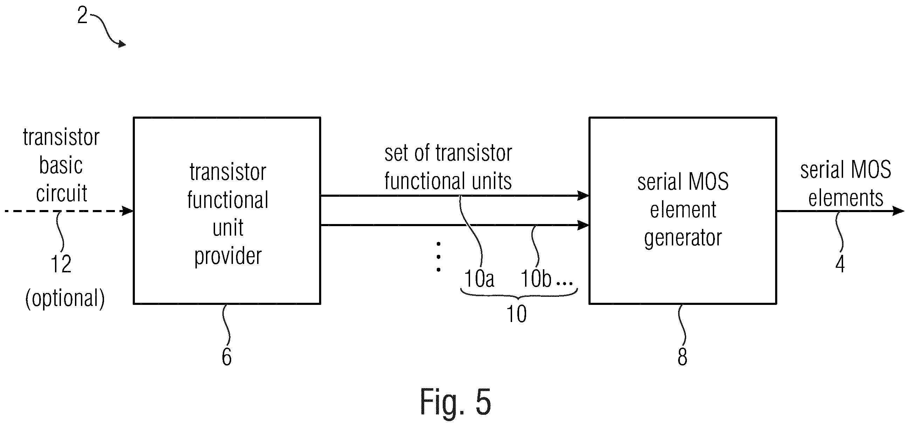

Fig. 5 shows a schematic block diagram of an apparatus 2 for generating serial MOS elements 4. The apparatus 2 comprises a transistor functional unit provider 6 and a serial MOS element generator 8. The transistor functional unit provider is configured for providing a set of transistor functional units 10, wherein each transistor functional unit 10a, 10b of the set of transistor functional units 10 comprises one transistor finger or a plurality of serially connected transistor fingers having connected gates. The serial MOS element generator 8 may be configured for generating at least one serial MOS element 4 by providing at least two serially connected transistor functional units 10a, 10b, etc. wherein the serial MOS element 4 inherits at least one layout parameter to the at least two transistor functional units. Such a layout parameter may be, for example, a gate width of the serial MOS element that is inherited to the underlying transistor functional units. In other words, all transistor functional units of a serial MOS element may comprise the same gate width if the corresponding (width) parameter or attribute is inherited from the serial MOS element to the transistor functional units.

A transistor finger may be a gate channel area with at least a gate area, a drain and a source area of a transistor representing a transistor entity in the layout circuit. The gate area is preferably on a gate conducting material which may be polycrystalline (poly) silicon. The source and drain areas are, in most CMOS technologies, drawn at least on a drain and source diffusion layer. The three areas (all three areas or an arbitrary selection thereof) may be connected to one or more metal layers. This or these metal layers then form the metal gate, source and/or drain contact.

A transistor functional unit may refer to a higher degree of abstraction when compared to the transistor finger. For example in submicron technologies and below, a transistor functional unit may be built from one transistor finger or from a series of fingers as, for example, shown in Fig. 1. In other words, the transistor functional units may be a representation of the transistor finger(s) on a higher hierarchy level than transistor fingers. Alternatively, each transistor functional unit may be formed using grouping of transistor fingers. In both cases, the transistor functional unit comprises at least one transistor finger. However, in larger technologies such as submicron and above (i.e. greater than 0.35 micrometer) or for coarse analog circuits, a fundamental MOS element may be built from one transistor finger and, therefore, for example in older or simplifying literature and schematics, there is traditionally no difference between the transistor finger and the transistor functional unit. Thus, the advantage to build a fundamental MOS element from a series of fingers may grow when technology nodes become smaller, such as in deep submicron technologies (i.e. 100 nanometer to 350 nanometer) and below. Due to the design rules in submicron technologies, it became difficult to form transistors with a great width and/or a great length.

A serial MOS element may refer to an object, virtual group or container of at least two transistor functional units connected in series to generate transistor circuits using a sequence of multiple instances of only a small number (for example, one or less than five) typically but not necessarily different fundamental MOS elements. Each fundamental MOS element may comprise attributes to adjust the functionality of instances of the fundamental MOS element by adjusting, for example, the size, shape and/or layer(s) of its geometrical implementation. Furthermore, when referring back to transistor functional units, the attributes or layout parameters of each transistor functional unit may be hidden in the structure of the serial MOS element. In other words, the serial MOS element is on a higher degree of abstraction when compared to a transistor functional unit. Thus, the serial MOS element comprises a higher hierarchical order compared to transistor functional units or the serial MOS element may be formed by grouping of transistor functional units. The external attributes or layout parameters of the serial MOS element are associated to the control attributes of the fundamental MOS elements so that the latter are controlled, for example together from one serial MOS attribute. This is advantageous where attributes should be equal for all fundamental MOS elements, for example like the gate width of the transistor functional units. Alternatively, the attributes may be controlled individually from one external serial MOS attribute where attributes may be different for the transistor functional units, for example like the gate length. Further parameters are introduced subsequently.

However, in addition to the above definition, a serial MOS element may, in a most simplified case, also comprise only one transistor functional unit made from a single transistor finger to realize the simpliest circuit that is possible. Thus, when referring to the object hierarchy, the transistor finger, the transistor functional unit, the serial MOS element, and any higher level objects may comprise the same transistor, i.e. there may be no difference in the objects.

An instance of the serial MOS elements may refer to an actually implemented serial MOS element being an individually and externally configurable representation of the fundamental MOS element. Externally configurable may refer to applying different connections and/or different layout parameters or layout attributes such as, for example, a different length or width of the serial MOS element to implement the desired circuit and to enable interface to external wirings perfectly.

To build a module circuit, multiple identical serial MOS elements or different serial MOS elements with only small variations such that they still fit into a grid are used. Therefore, the attributes are adjusted only once for the comprising or underlying sequence of fundamental MOS elements although these fundamental MOS elements are used or instantiated several times. Thus, a module is referred to a higher degree of abstraction when compared to the serial MOS elements. For the sake of completeness, a block may be referred to the view having the highest degree of abstraction or the highest hierarchical order.

The transistor functional unit provider 6 may provide the set of transistor functional units 10 from a predefined general set of transistor functional units and/or optionally by analyzing a transistor basic circuit 12 to identify transistor functional units in the transistor basic circuit. Therefore, the serial MOS element generator may be configured for generating the at least one serial MOS element using analyzing a transistor basic circuit and identifying structures of the transistor basic circuit to form the at least one serial MOS element based on the smallest identified series of transistor functional units of the basic transistor circuit. Alternatively, the transistor functional unit provider 6 may be for example a database where the set of transistor functional units is stored. Thus, the set of serial transistor functional units may comprise generally applicable transistor functional units that may be used to form serial MOS elements.

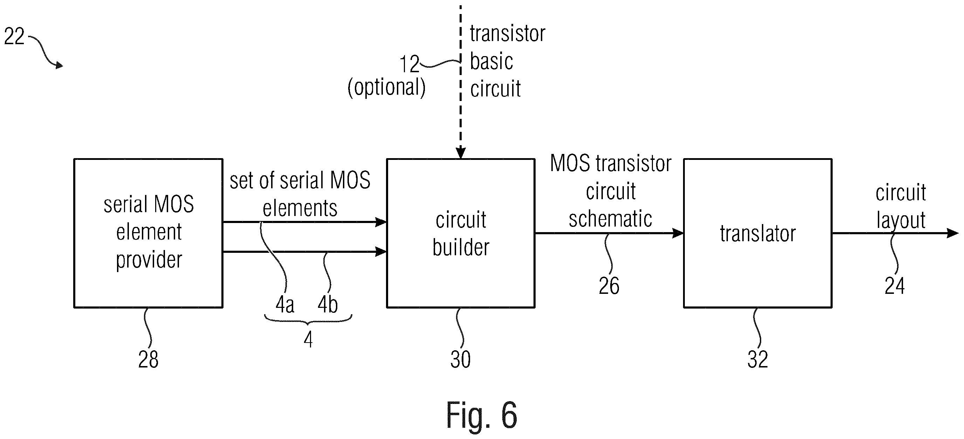

Fig. 6 shows a schematic block diagram of an apparatus 22 for building a circuit layout 24 from a MOS transistor circuit schematic 26. The apparatus 22 comprises a serial MOS element provider 28, a circuit builder 30 and a translator 32. The serial MOS element provider may be configured for providing a set of serial MOS elements 4, wherein each serial MOS element 4a, 4b, comprises at least two serially connected transistor functional units, wherein the at least one serial MOS element inherits at least one layout parameter to the at least two serially connected transistor functional units. According to embodiments, the serial MOS element provider 28 may be the apparatus 2 as described with respect to Fig. 5. Alternatively, the serial MOS element provider may be for example a database where the set of serial MOS elements is stored. Thus, the set of serial MOS elements may comprise generally applicable serial MOS elements that may be used to form various circuit schematics.

The circuit builder 30 receives the provided set of serial MOS elements 4a, 4b from the serial MOS element provider regardless of whether the set of serial MOS elements are general serial MOS elements or whether the set of serial MOS elements was determined by analyzing a transistor basic circuit or by using predefined transistor functional units. In other words, the circuit builder may be configured for building the MOS transistor circuit schematic 26 using one or multiple instances of the at least one serial MOS element and wherein the circuit builder may be further configured for building the MOS transistor circuit schematic based on the layout parameters of each instance of the multiple instances of the at least one serial MOS element 4.

Thus, the circuit builder uses the serial MOS elements to form a circuit schematic (such as a circuit diagram or a netlist) having a desired functionality. According to further embodiments, the circuit builder may rebuild a transistor basic circuit 12 to form the MOS transistor circuit schematic with serial MOS elements such that the MOS transistor circuit schematic formed with serial MOS elements has the same functionality when comparted to the transistor basic circuit. From the MOS transistor circuit schematic 26, a translation of the circuit schematic into the circuit layout may be directly applicable. Therefore, it is advantageous that the layout parameters may be attributes of the serial MOS elements (and that the serial MOS element is therefore directly convertible from the respective ciruit in the schematic) and that serial MOS elements may furthermore be designed to be directly abuttable.

Thus, the translator 32 is configured for translating the MOS transistor circuit schematic 26 into the circuit layout 24 using the serial MOS elements' layouts. Again, since instances of the serial MOS elements may be placed adjacent or directly abutting to other instances of serial MOS elements, the translation may be performed without regard to certain spaces between different layers of the resulting (substrate) circuit layout. In other words, the circuit layout may be determined using the (layout) properties or attributes of the serial MOS elements based on the arrangement of the serial MOS elements and the respective wiring or electrical connection from the generated MOS transistor circuit schematic to form or to generate the layout of the MOS transistor circuit schematic.

Thus, the translator may perform a transformation of the topology from the circuit schematic into the circuit layout. The circuit layout may refer to a layout view of the transistor circuit schematic indicating how to implement the different layers of the transistor circuit geometrically throughout the various steps of production into a semiconductor substrate or an insulator substrate, such as, for example, glass or diamond.

(Directly) abutting may refer to drain and/or source contacts, such as, for example, doped semiconductor areas of two transistor fingers being attached to each other, merged, or commonly used, in order to avoid a wired connection between both contacts. Furthermore, a direct abutting of serial MOS elements is also possible on the two gate contact sides, for example to form a common gate contact or a common back gate contact of two or more instances of serial MOS elements, transistor functional units, or transistor fingers. However, directly abutting may also refer to using a further direct electrical connection between the areas to be abutted, for example by using a short straight or a rectangular (metal) wire. Moreover, this wiring to form the directly abutted serial MOS elements is preferably as short as needed to provide minimum distance between diffused doping regions while ensuring proper manufacturing and electrical function. Such a direct connection may also reduce the wiring effort and complexity of the circuit layout when compared to an (individual) indirect wiring having multiple vertices or a greater length or size. Moreover, to form directly abuttable devices, e.g. doping regions such as drain/source/gate regions or contacts thereof may be formed outmost, closest or in certain distance to the frame of the serial MOS element in the layout.

More specifically, directly abuttable may refer to the alignment border 70, which may be a frame of the serial MOS element, where different instances of serial MOS elements can be aligned without taking any individual or separate spacing requirement of the different layers into account. Thus, the direct abutment may be a layout parameter indicating whether the drain/source region of the serial MOS element is connected to a drain/source region of subsequent serial MOS element to form a common drain or source region of the subsequent serial MOS elements or whether an additional wiring shall be performed to form the connection between the subsequent serial MOS elements. Thus, it is possible to place the different instances of the at least one serial MOS element (always) with the same spacing to subsequent instances of the at least one serial MOS element regardless of whether a shared drain/source region or a wired connection is used.

Furthermore, the layout of the serial MOS elements, and therefore the circuit layout, should satisfy or be in accordance to a number of design rules. These design rules may refer to geometrical properties, such as spacings, minimum or maximum size, e.g. minimum/maximum height/width, abutting/not abutting adjacent contact areas or overlapping parts of the serial MOS elements or their respective instances etc. that should be satisfied by all drawn shapes of the serial MOS elements to obtain a realizable layout for the manufacturing of the circuit. The definition of these design rules may refer to the serial MOS element itself, with respect to shapes on the same layer or with respect to shapes of different layers.

The described apparatuses or the corresponding methods basically rely on arranging schematic data
- differently than the traditional way, so that it's possible to keep the data structure the same in schematic and layout and to keep the design intend;
- hierarchically in a way that there are objects to carry designer's expertise as properties effectively.

So layouter's expertise controls automatic layout generation by setting a few properties on the correctly clustered schematic objects instead of by manipulating the layout process while it is applied to many objects or even by doing the layout process details manually. Moreover, data may be kept consistently in schematic and layout. Therefore forward and backward annotation of properties is no problem.

For definition of the Serial MOS configuration, it may be referred back to Fig. 2. In the right circuit of Fig. 2, there are two horizontal connection ds1011 and ds1112 and the devices are usually drawn as iterated instances or with a parameter of parallel multiplicity. That's why the circuit is traditionally seen as made from parallel devices.

Because there is the same current into the same devices in each column there are the same voltages across the points of each net, even when they are left out, these connections are not needed for correct operation of the circuit. When they are left out the circuit is obviously made from serial devices.

Furthermore a single "for the circuit functional transistor finger" can also be seen as a serial configuration of the transistor parts "drain", "gate" and "source". Therefore it makes sense to see a single transistor with one finger as the simplest case of a serial configuration with one device.

A serial configuration is composed from transistors that can freely be sized but preferably have the same gate width for easy alignment. In this document this serial configuration will be called serial MOS configuration.

Optionally, an existing data structure (e.g. schematic or netlist) may be transformed to derive circuits made of serial MOS arrangements. Any analog circuit can be partitioned in modules which can be realized by a plurality of identical serial MOS elements. When the circuit is not already drawn based on serial MOS there is a way of decomposition that can transform the circuit data into a structure based on serial MOS.

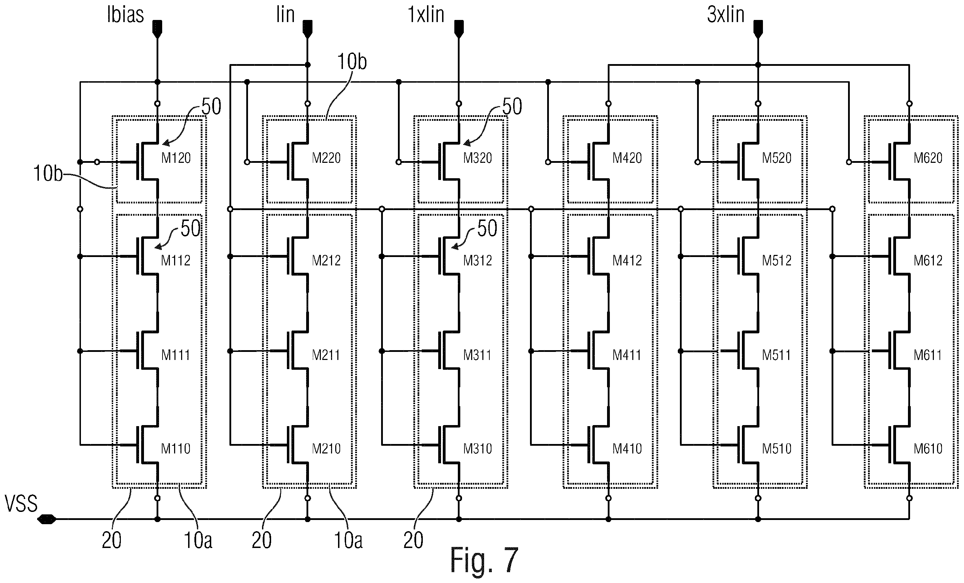

The plurality of preferably identical serial MOS configurations may be drawn side by side in the schematic, building a transistor device array where the columns are represented by the serial MOS configurations as can be seen in Fig. 7.

Fig. 7 shows a schematic circuit diagram (circuit schematic) of a current mirror circuit. The labels adjacent to each transistor finger 50 may refer to a certain notation, where the letter and the first digit, for example M1, indicate the first module 20, the third position, i.e. the second digit, indicates the transistor functional unit 10a, 10b of the aforementioned module 20 and the last position may indicate a consecutive numbering of the transistor fingers within the transistor functional units. This labeling may be used for the further figures as well.

Normally, designers group the columns and replace the rows of identical transistors of each column group by a single transistor having a multiplicity by means of an adequate property or iterated naming. This defines the structure of the start point data. For special circuits like Biasing diode connected devices, it might be useful to mutate one column group to willfully introduce irregularity, for example by reducing width of one device to enlarge bias voltages. This or other special cases can also have a plurality of one for the number of serial configurations.

Inside the serial MOS configuration, there is a drain-source connection between all transistors, i.e. transistor fingers or transistor functional units, situated right above each other. On top and on bottom the configuration ends with a source or drain connection. The drain, source and gate pins of the serial MOS configuration are each of them separately treated all the same inside the column groups. There is no connection to other column's different pins. Connections are only formed to the same pin in the own column or to the same pin in the other columns. For some type of module there are additional connections necessary between the pins of different types. For example, when connecting the gate to the drain of a current mirror input transistor.

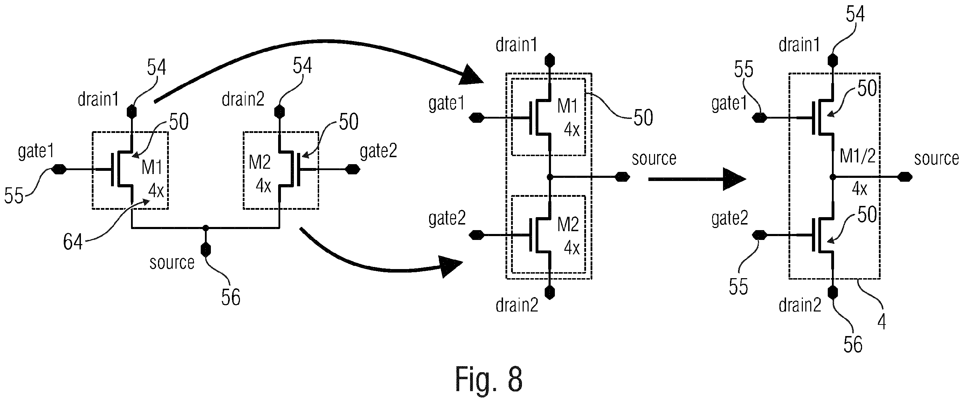

Fig. 8 shows a further embodiment. Here, the process from having a basic transistor circuit (a differential pair), redrawing the differential pair in a serial order and merging or direct abutting of the transistor finger 50 (indicated by M1 and M2). The multiplication factor (4x) 64 indicates the actual number of instances used to form the actual transistor circuit. In other words, a differential pair can also be seen as a serial configuration as shown in Fig. 8.

The serial connection between the modules indicated in the middle of Fig. 8 may be directly transferred into the serial MOS element in the right circuit diagram of Fig. 8. The direct abutting of the transistor fingers as a feature of the serial MOS elements may be deduced in the schematic from the dissolving of the single transistor fingers M1 and M1 and the forming of the resulting serial MOS element M1/2 4.

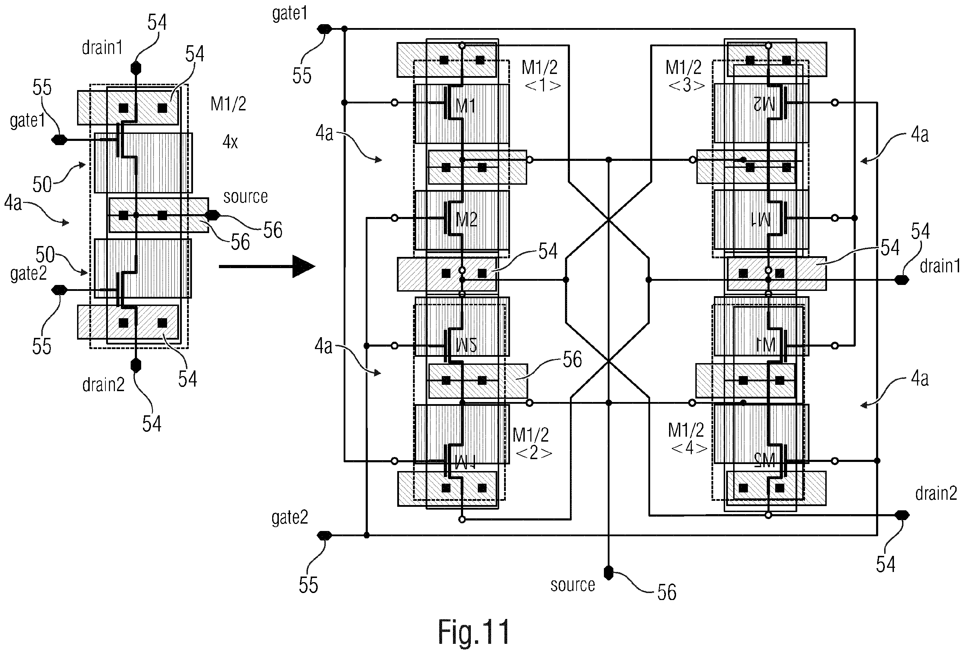

This transformation from the left drawing of Fig. 8 to the right drawing of Fig. 8, i.e. from the basic circuit schematic into serial MOS elements, may be performed by the apparatus 2 for generating serial MOS elements. The following figures (until Fig. 11) describe the forming or creating of the layout for a differential pair circuit.

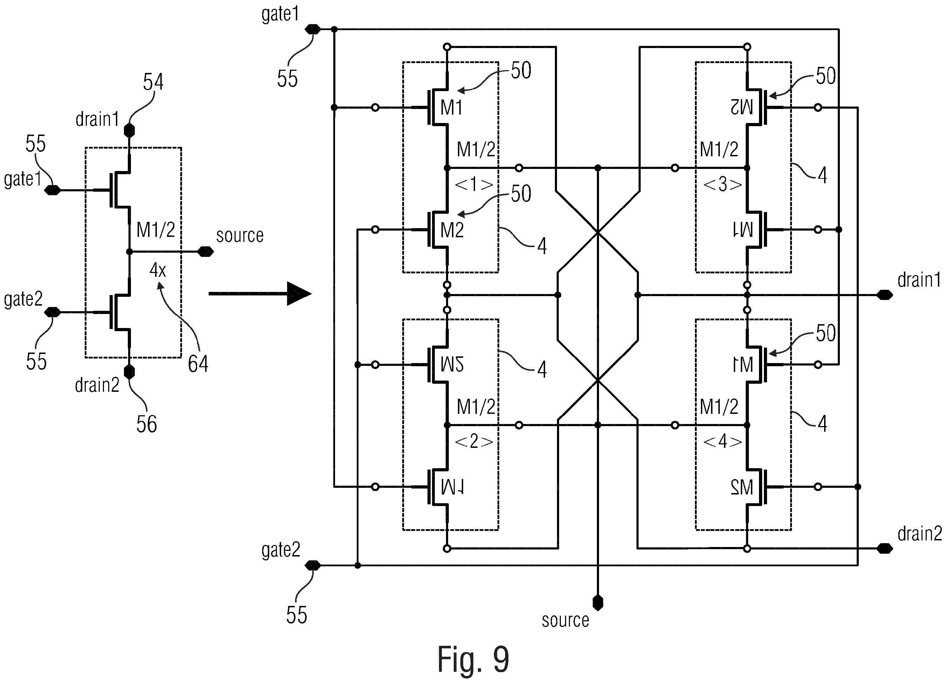

Basic building block of the differential pair circuit of Fig. 9 is a serial MOS element 4 of Fig. 8 containing one finger of M1 and one finger of M2.

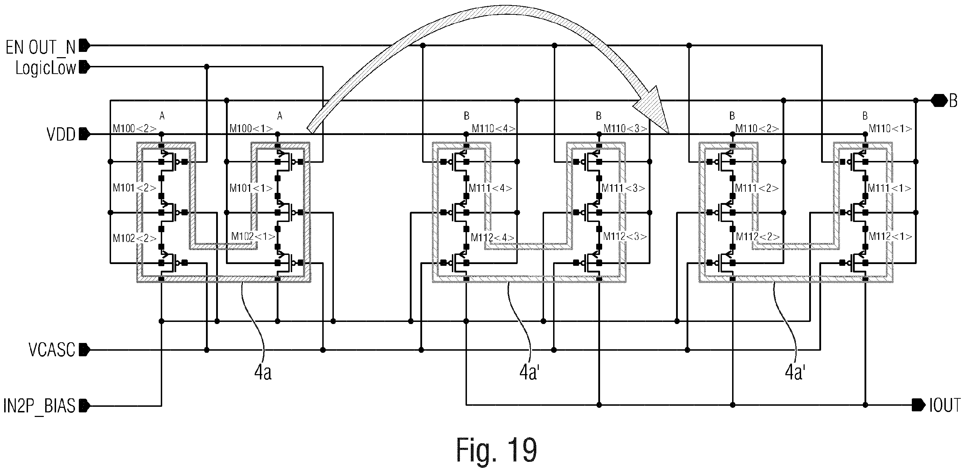

The structural change often transfers a U shaped circuit into a linear configuration. This can be seen in this small example of Fig. 8 and in more detail in the example shown in Fig. 19.

Once the serial MOS parameters are derived by circuit decomposition, the designer can choose serial MOS's layout style by setting its parameters once for all modules in this circuit, and finally create the layout by serial MOS placement and routing. The serial MOS element's layouts should be carried out so that they can be abutted at their alignment border 70 either sharing drain/source areas or having drain/source separated to the next module. Then serial MOS can be aligned in a desired pattern and wiring completes the layout. Any finger is placed multiple times in the circuit by placing the serial MOS multiple times. The circuit of Fig. 9 consists of four identical serial MOS modules.

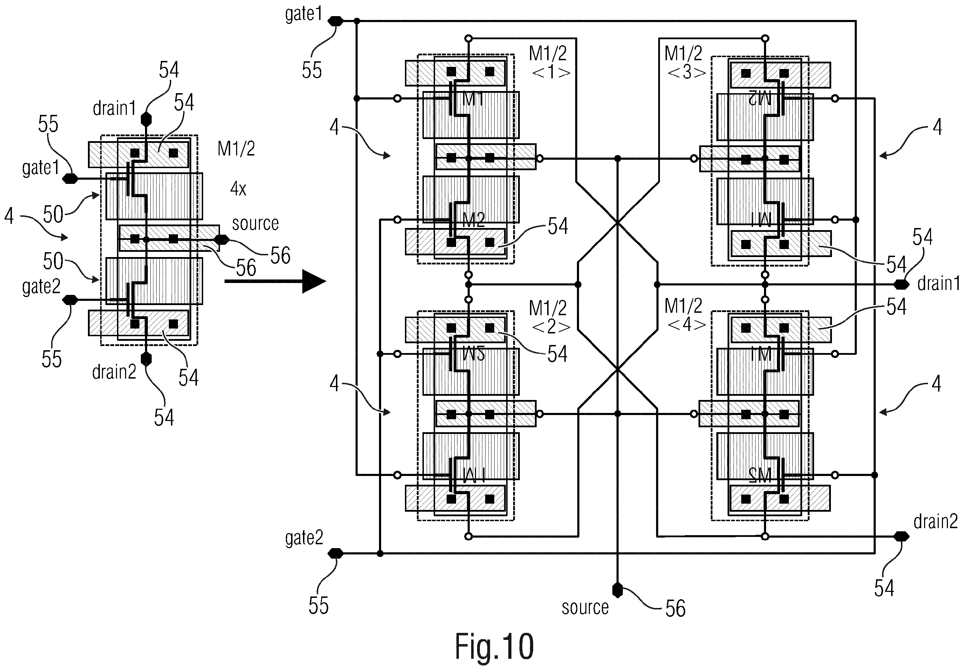

Fig. 10 indicates on the left, the corresponding serial MOS layout of the circuit of Fig. 9, which can be derived easily from the schematic on the left of Fig. 9. The serial MOS layout is placed four times in four different orientations as indicated in the circuit schematic on the right of Fig. 9. Wiring can also be done like sketched in the schematic.

The serial MOS layouts should be created in such a way that alignment can be accomplished easily and that sharing source regions 56 inside the serial MOS and drain regions 54 when aligning is feasible, if desired. Abutment or joining area of pins, direction and properties of connection may be the same for one kind of pin in all serial MOS modules.

Fig. 11 reveals, according to an embodiment, that the serial MOS element generator may be configured to generate the at least one serial MOS element 4a such that an instance of any serial MOS element in a circuit is directly abuttable to a further instance of each of the at least one serial MOS elements in this circuit. This is revealed especially when comparing Fig. 10 and Fig. 11, whereas in Fig. 10, the serial MOS elements are connected using a wiring or a metallization, in Fig. 11 a common or shared drain part 54 of the serially connected serial MOS elements is formed and therefore the serially connected serial MOS elements 4a are directly abutted.

Furthermore, the left layout of Fig. 11 reveals that the serial MOS element comprises two electrically separated or isolated gates 55. Thus, the serial MOS element generator may be configured for generating the at least one serial MOS element comprising at least two gates, wherein the at least two gates are (electrically) insulated from each other.

According to embodiments, Fig. 10 and/or Fig. 11 reveals, as indicated by the common or shared source region 56 that the serial MOS element generator may be configured to generate the at least two serially connected transistor functional units by directly abutting drain or source areas of the serially connected transistor functional units. This may be referred to as internal abutment.

According to further embodiments, the serial MOS element generator may be configured to subsume inherited layout parameters of the same kind of the at least two transistor functional units. Furthermore, the serial MOS element generator may be configured to generate the at least one serial MOS element such that the serial MOS element commonly controls the inherited layout parameters of the same kind of the serially connected transistor functional units. In other words, for example Fig. 11 reveals that a common parameter, for example a width of the transistor functional units, may be inherited from the serial MOS element to the transistor functional units. Therefore, the width of the serial MOS element may be, independent from the number of underlying transistor functional units or transistor fingers, adjusted only once.

Thus, according to a further embodiment, the serial MOS element generator may be configured to generate the at least one serial MOS element as a module or as a group of transistor functional units to allow generating multiple instances of the least one serial MOS element. In other words, a hierarchical structure may be formed having on the lowest level, for example the transistor fingers, on a level above, the transistor functional units, on a third level the serial MOS elements, on a fourth level the modules, and on the fifth level the blocks as already described earlier. Thus, the serial MOS element may be instantiated multiple times to form the actual circuit schematic. However, without such an hierarchical order, the transistor functional units may be grouped together to form the serial MOS element, such that the group may be placed multiple times or cloned within the circuit schematic. The serial MOS element provider may be configured to generate the at least one serial MOS element from transistor functional units having at least partially identical layout parameters. One of the identical layout parameters may be, for example, a width of the serial MOS element that may be inherited to the width of the underlying transistor functional units. However, there may also be parameters or attributes that should be adapted separately for each transistor functional unit of a serial MOS element. Such an individual parameter may be a gate length or a number of unit transistors or unit functional units forming the serial MOS elements. In some cases, the serial MOS elements may also be formed of transistor functional units having all the same properties by setting the individual parameters to identical values.

Furthermore, when referring to the apparatus 22, the circuit building may be configured to use the at least one serial MOS element as a module or as a group of transistor functional units.

In embodiments referring to hierarchies or grouping of elements, function blocks such as the transistor functional units to form the serial MOS elements or the circuit builder to build the circuit layout, the hierarchical object (such as a serial MOS element) may be referred to as a parametric cell (p-cell or pCell). This p-cell forms an object of the serial MOS element, which may be instantiated multiple times. If using a parametric cell, it may be referred to the serial MOS building as a (dynamic) serial MOS generation. Herein, the builder as a generator receives parameters or attributes and generates instances of each serial MOS element independently based on the saved layout parameters and the received attributes. Thus, each instance may refer to a newly generated serial MOS element. Alternatively, the circuit builder may be a static (layout-) generator using groups instead of objects and therefore using existing serial MOS elements to form the transistor circuit instead instances. However, further groups may be built by copying or cloning the group instead of newly generating the same as an instance. Still, by copying the serial MOS elements new parameters or attributes may be provided to the newly generated serial MOS element. Nonetheless, for the sake of simplicity, the groups are also referred to as instances. Moreover, since instances of the serial MOS element are only an applied representation of the serial MOS element, when referring to a serial MOS element it may also be referred to each instance of the same.

Further, common parameters may be a drain source contact in between consecutive transistor functional units. If at least one of those drain source contacts is formed, it may be advantageous to generated such a contact for each drain source connection. In other words, if one drain source connection is needed, such a connection may be formed for each drain source connection between transistor functional units of the serial MOS element. However, if only the desired drain source contact is formed, this property may be seen as an individual property. However, since a metal layer may be formed to contact the drain source connection, the effort to contact all drain source contacts instead of one is not increased. A further common parameter may be the type of metal used for the metal layers or whether further drift diffusion areas shall be formed, for example to integrate a resistance into the layout for example to enhance operating voltage range of the transistor circuit. In other words, these parameters or attributes influence the geometrical implementation of each serial MOS element with respect to a size, a form or a level where different layers are arranged.

However, the actual layout generation, as for example the conversion or transformation from Fig. 9 to Fig. 10 or Fig. 11, may be performed by the apparatus 22 for building a circuit layout from a MOS transistor circuit schematic. According to embodiments, the translator may be configured to translate serially connected serial MOS elements from the MOS transistor circuit schematic into directly abutted serial MOS elements in the circuit layout. This may be referred to as a translation of Fig. 9 into Fig. 11, where serially connected (instances) of serial MOS elements 4 are directly abutted at adjacent drain contacts, respectively.

According to further embodiments, the circuit builder may be configured to only use instances of the at least one serial MOS element 4 to generate the MOS transistor circuit schematic. This embodiment is revealed in all described figures, where only serial MOS elements or, more specifically, instances of serial MOS elements are used (i.e. placed and wired) to form the circuit schematic and thus, the circuit layout. Moreover, the circuit builder may be configured for generating the transistor circuit schematic using instances of exactly one serial MOS element. The described embodiments relate, for the sake of simplicity, only to circuits using instances of one serial MOS element. However, it is also possible to have different serial MOS elements such that circuits may be formed of instances of two or more different serial MOS elements.

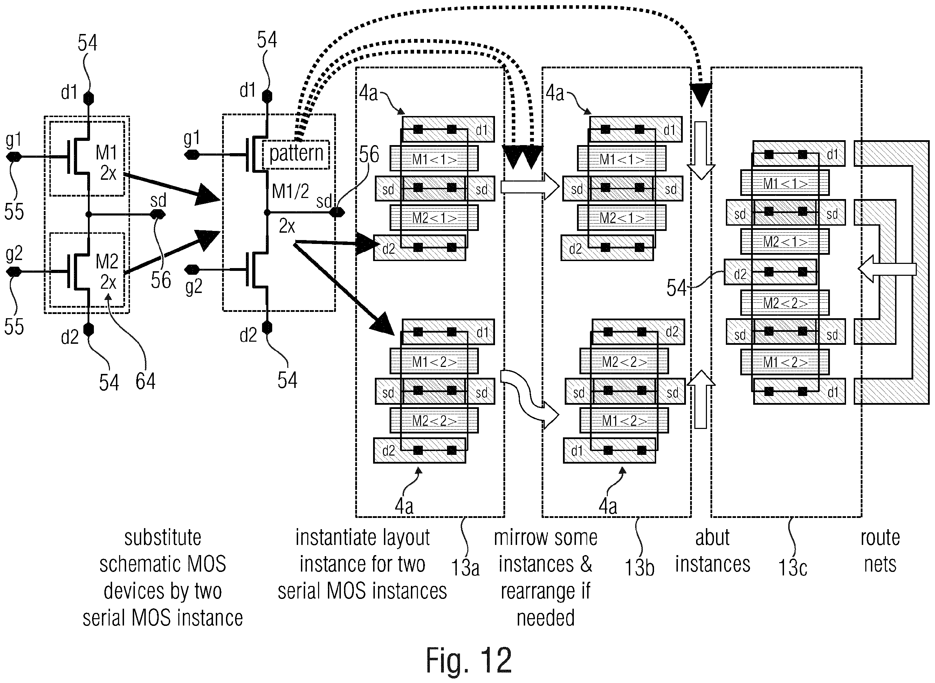

In other words, when Fig. 12 is compared to Fig. 3 and Fig. 4 it can be seen by the number of white arrows indicating the transitions between consecutive incomplete layouts 13a, 13b, 13c that the new algorithm has a lot smaller degree of freedom while leading to the result 13c which is the same result as 11d. Obviously rearranging the order of operations and reorganizing the problem creates less objects for placement. They have the same structure and therefore can be combined. The serial MOS object stores information for the following layout process that can easily be carried out by a program.

The new method may comprise the following steps:

### Step 1A - For already designed circuits:

Decomposition of traditionally drawn circuits into serial MOS arrangements
- identify serial MOS configuration(s)
- Redraw the circuit's schematic and add additional hierarchy to represent the circuit by means of serial MOS module(s).
- Instead of additional hierarchy mechanisms like grouping and cloning are also adequate for this when available.

Thus, according to embodiments, the circuit builder may be configured to restructure the transistor basic circuit using the at least one serial MOS element to generate the serial MOS transistor circuit.

### Step 1B - For new circuits:

creation of new circuits using serial MOS arrangements
- Take serial MOS as building block(s) for the circuit's schematics.

However, instead of a module schematic, a netlist or other data representation may be used in all steps.

### Step 2 - Refining serial MOS parameters for perfect internal layout:

- define internal transistor abutment style,
- other serial MOS's internal properties and
- external abutment style properties

The refining of the serial MOS parameters may refer to gaining or receiving additional layout information that is absent in the schematics derived after step 1A or step 1B. This layout information may refer to, for example, defining a contact area, operating the serial MOS element in a forward or backward direction, adjusting the spacing between gates of the transistor functional units, specifying the levels of the layers where connections are contacted, or specifying whether gates of the transistor functional units are contacted or internally wired.

### Step 3 - create layout for serial MOS module(s) from the schematic or netlist and the refinement.

### Step 4 - place serial MOS module(s) into Patterned array

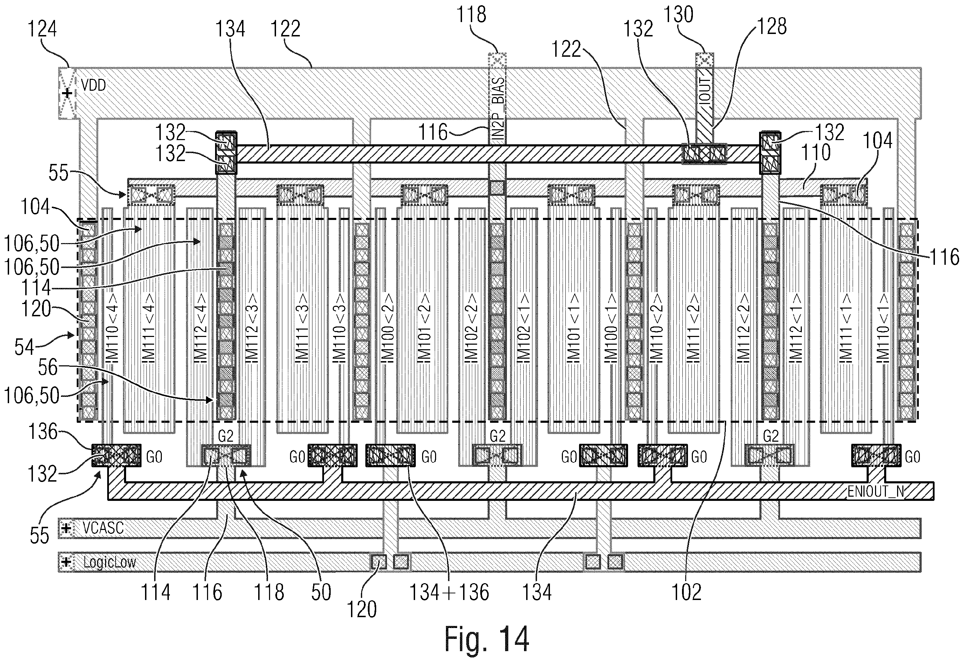

Therefore, the translator may be configured to arrange a layout of the instances of the at least one serial MOS element such that the circuit layout is arranged in a patterned array. As a patterned array, a centroid arrangement of the serial MOS elements may be referred to, such that, for example, fabrication errors are compensated throughout the entire circuit. An exemplary patterned array arrangement is shown in Fig. 14.

Step 5 - Wire connect the serial MOS's pins that are not already connected by abutment and place module pins, if desired.

In other words, the translator may be configured to form wired connections of pins of the multiple instances of the at least one serial MOS element and/or wherein the translator may be configured to form connections using abutting of the multiple instances of the at least one serial MOS element according to the connections indicated in the MOS transistor circuit schematic. In other words, connections between serial MOS elements may be performed using abutting of consecutive serial MOS elements. However, any further connection indicated in the circuit schematic may be built by additional wiring or using additional metallization layers.

Optional step 6 - add more layout structures like common well shapes, well contacts and guard rings.

In other words, the translator may be configured to arrange bulk contacts or back contacts 60 of a semiconductor substrate or well in the circuit layout.

Three hierarchical levels of object data should be defined to create a circuit module in this way:
1. Definition of all properties of each transistor, i.e. transistor functional unit or transistor finger inside the serial MOS confguration(s) and their placement and routing style. Because there are only a few of them it is feasible for the designer or the automated cad tool to define them. This is done in Steps 1A or 1B.
2. Definition of the serial MOS module's placement, including arrangement pattern and abutment styles of the serial MOS modules. This information is input for Step 4 but can be defined already in 1B or 1A.
3. On module top level there are the definitions of
   - the routing and pin properties of each net needed for step 4 and 5 and
   - other common infrastructure definitions like well contact properties etc. that can be used to generate more layout structures needed on this level in an additional step 6.

This enables easy design of MOS transistor circuit's layouts manually or with an automated flow using serial MOS elements instead of single MOS devices. Thus, it may be applied a procedure of "normalizing a database representation structure" from database theory.

According to further embodiments, the described apparatus and methods may be advantageously applied to analog devices wherein, however, the same may also be applied to digital devices or current mode logic circuits (CML circuits).

According to embodiments, the circuit schematic may be referred to as a digital representation of a data structure of an electric circuit having elements and connections stored in an electric and functional way.

In other words, structuring the circuit with serial MOS creates an adequate and canonical partitioning of the schematic to ease the layout creation of transistor circuits.

This reduces the degrees of freedom for implementation significantly, because
- common properties are bundled and processed together so that there is no redundancy in the database and
- new objects are created in schematic as well as in layout that previously only existed sometimes in layouts made manually by experienced designers.

The point is, that the transistors of the serial MOS configuration influence each other's layout so much that they should be treated together as a primitive circuit element. One example is a shared drain-source-region without contact and metal shape that completely changes the abutting side of each transistor finger.

The layout inside the serial MOS configuration has heavy dependence on the various device's properties. Outside there is arrangement or abutment without influence on the layout inside the serial MOS because while generating serial MOS it is assumed that the serial MOS are surrounded by other serial MOS. So if it is possible to generate a serial MOS layout with all complicated layers and layer dependences, any circuit can be generated or drawn easily by arranging and wiring serial MOS modules. This has a heavy analogy to digital standard cell design where the logic gates are complex but circuit generation is done by place and route.

Therefore the design of analog blocks especially for precision applications can be done
- with less effort,
   ∘ because the designer has to set a fewer number of properties that are mapped to all subelements that are identical. Previously device "bundling" was not so effective because there were many of them, each of them with properties to be set correctly.
   ∘ when designers can generate serial MOS layouts automatically they only have to know the metal and alignment distance rules for layouting the rest.
   ∘ when designers can generate serial MOS layouts simply by defining serial MOS properties there is only a place and route procedure left that can be automized easily. This corresponds to Synthesis and P&R (place-and-route) procedures for semi custom digital circuit design.
- and higher quality
   ∘ because data hierarchy ensures that properties to be the same are the same;
   ∘ because there are objects to bare the properties previously transferred from schematic designer to the layouter by notes or device to device constraints, which is not the right mapping relationship;
   ∘ because with the same effort more circuits can be layouted perfectly.

In layout there is only wiring on metal layers left beside the serial MOS modules when we take the following into account:
- A serial MOS structure has well defined geometrical surrounding and can be accessed easily by a pin to trunk router.
- A serial MOS structure has a limited number of properties so a pCell or generator implementation has limited complexity. Expert knowledge can be implemented on a very high level.
- But with serial MOS the designer or a generator can create an unlimited number of different circuit structures.

First it looks more complicated to apply that procedure but in the end this will simplify the creation of perfect layouts for analog circuits very much.

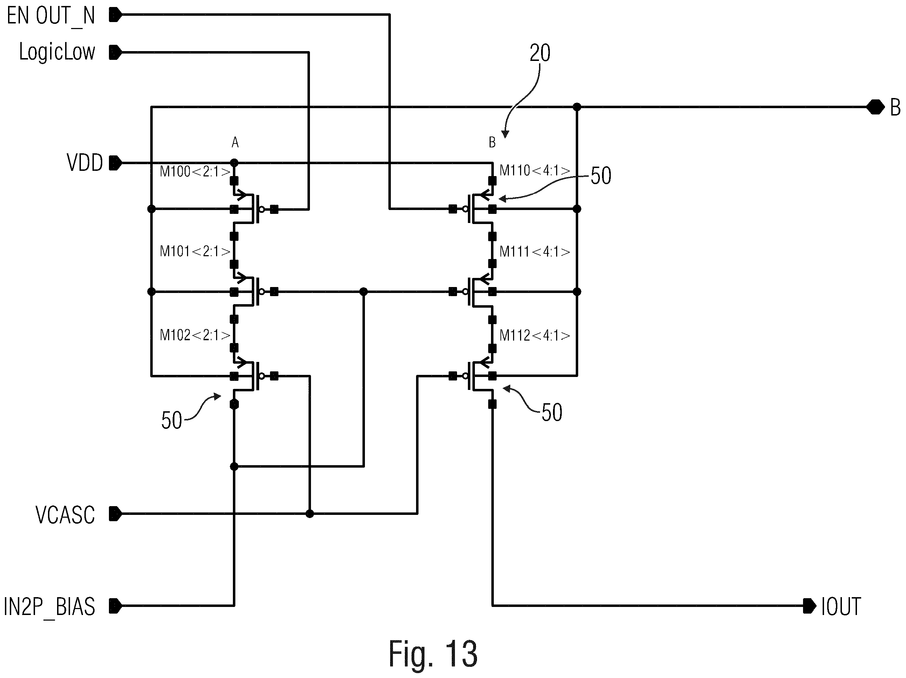

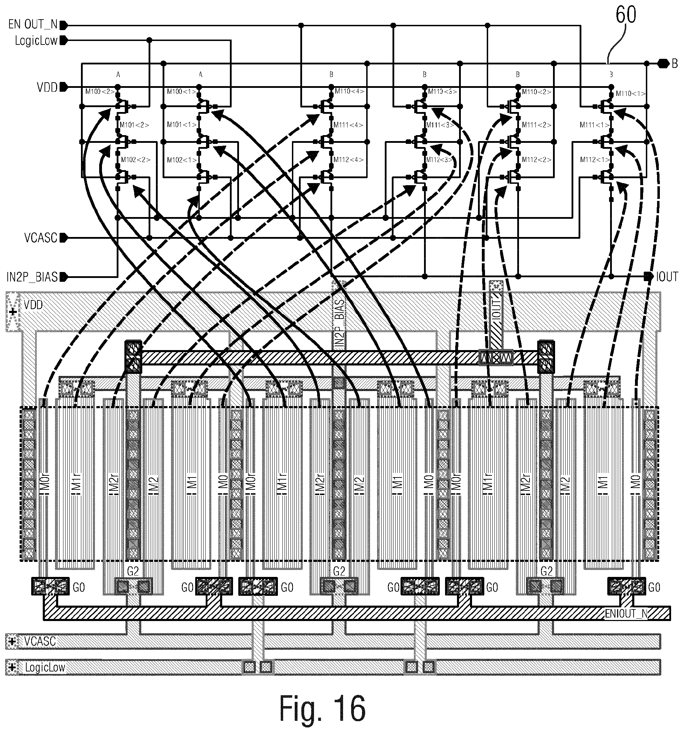

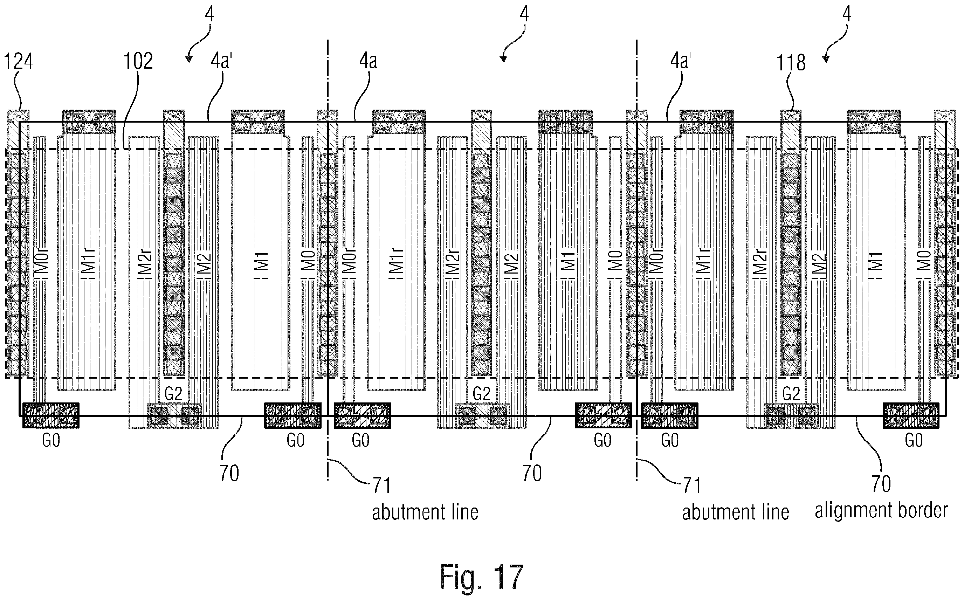

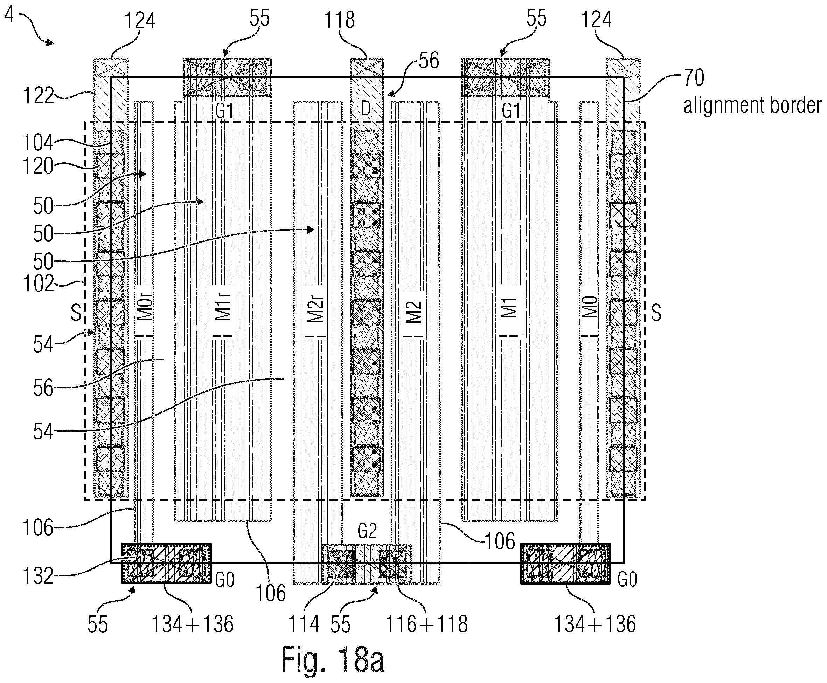

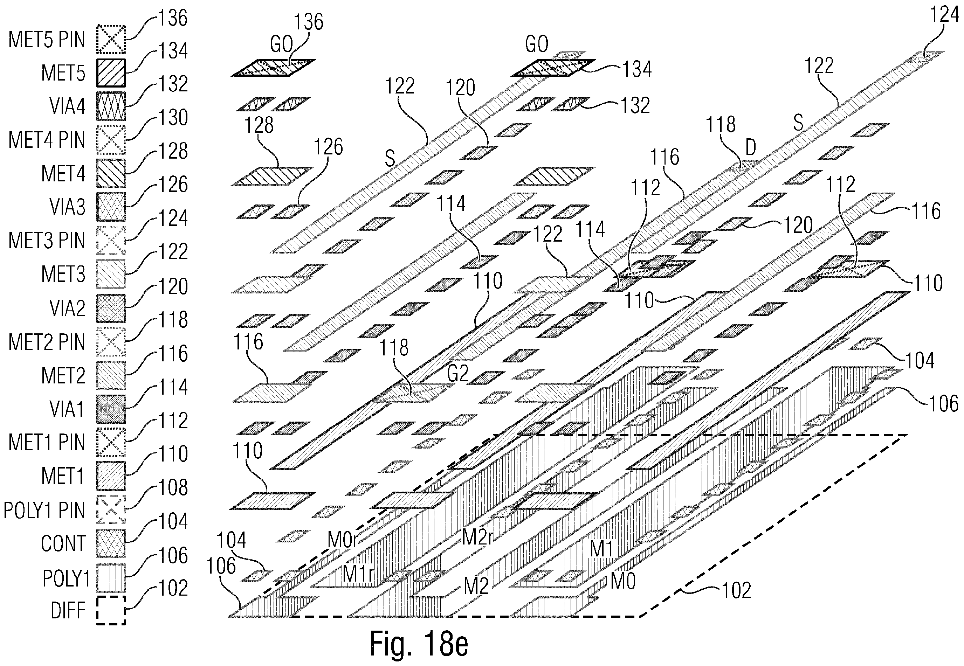

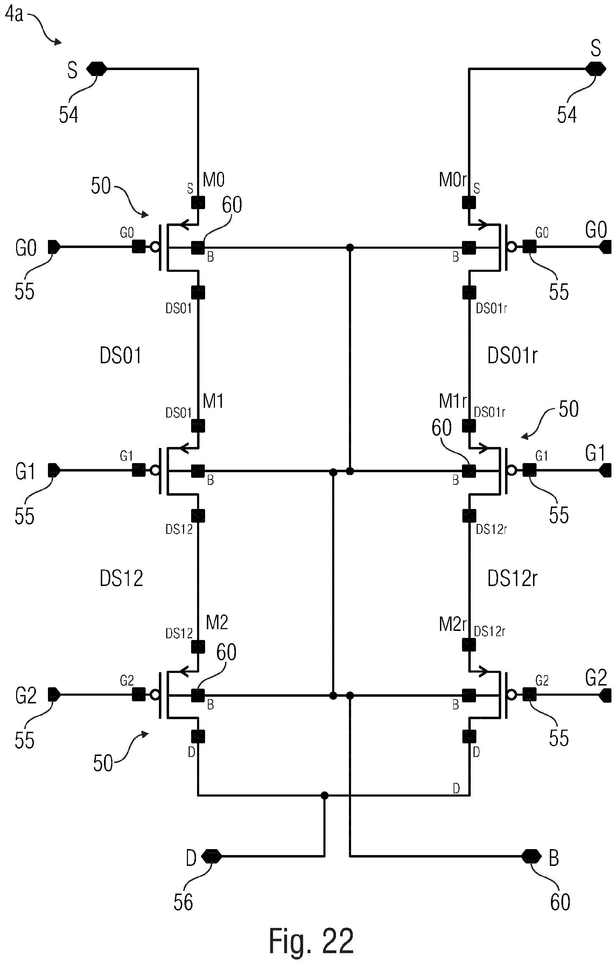

Fig. 13 to Fig. 22 show an exemplary conversion of a basic circuit (switched mirror). The process to form a serial MOS representation will be shown both in schematics and layouts. In the layout representations, different hatchings and/or different edges may refer to different layer and/or level of the layout. Moreover, the legend of Fig. 18e may also be applied to any other layout drawing, i.e. Fig. 14, Fig. 16, Fig. 17, Fig. 18a. Moreover, all of the aforementioned layout drawings are based on the same implementation, where only the serial MOS elements are indicated in a different way. More specifically, Fig. 22 shows the schematic and Fig. 18a to Fig. 18e show the layout of one serial MOS element, which is used three times in Fig. 14, Fig. 16 and Fig. 17 to form the layout of the actual switched mirror circuit. Furthermore, it has to be noted that the fingers denoted in the layout views Fig. 17 and Fig. 18a as well as in the schematic Fig. 22 are referred to as M0, M1, M2, according to the last digit of the other schematic's Transistor names wherein an appended r denotes a reverse order and placement of fingers when compared to the corresponding fingers without appended r. The correspondence between the transistor fingers in placed in layout and the transistor fingers in schematic is shown in Fig. 16. None of the layout figures 14, 16, 17 or 18 show the implementation of a bulk or well contact 60 which has to be added e.g. as a ring around the serial MOS elements. Additionally or alternatively, the bulk or well contact may be included in a serial MOS element.

In other words, the serial MOS element generator 8 may generate the at least one serial MOS element 4 having a bulk contact 60 as a layout parameter. Thus, besides the drain, source and gate contacts, the serial MOS element may further comprise the bulk contact. The bulk contact may be formed between (internally) directly abutted transistor functional units, e.g. between adjacent connected drain or source regions. Additionally or alternatively, the bulk or backgate contact may be formed at a border of the serial MOS element.

The described example module is a switched current mirror from a PLL charge pump. Fig. 13 shows the schematic of the circuit as a designer would draw it from scratch. The corresponding implementation, drawn by a layout engineer would look like Fig. 14. There may be not much effort in the wiring metal details for this example. The transistor fingers 50 are represented by the poly stripes 106 arranged vertically on horizontal diffusion stripes 102. In this example it is one stripe.

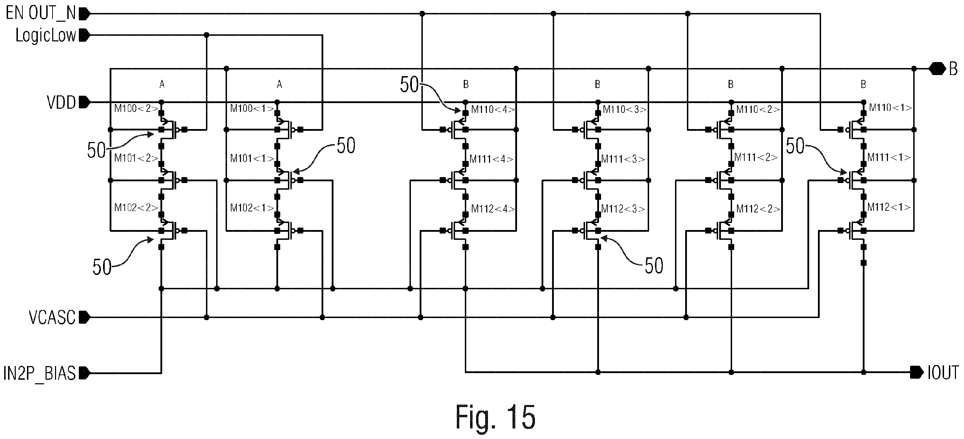

To see the fully expanded structure, the circuit of Fig. 15 shows all transistor fingers 50 separately. In other words, Fig. 13 shows the circuit on a module level wherein Fig. 15 shows the same circuit on transistor finger level. In layout, the MOS transistor fingers 50 are placed into a highly symmetrical and compact geometrical arrangement. Common drain 54 and/or source 56 areas and contacts may be shared.

Fig. 16 shows the correspondence between the MOS fingers in schematic and layout. More specifically, Fig. 16 is formed using Fig. 14 and Fig. 15 and further by indicating the corresponding transistor fingers by arrows. In the new implementation, the transistor stack is composed from three identical submodules(cf. Fig. 17), i.e. serial MOS elements, rather than from 18 separately aligned subtransistors. The serial MOS elements realize a series of three transistors both forth and back . Fig. 18a and Fig. 18e show the submodule, i.e. the serial MOS element having a rectangular alignment border 70. In Fig. 17 the three serial MOS elements are abutted so that their alignment border rectangles touch each other at the alignment lines 71. The serial MOS layout is created so that e.g. on some layers some shapes may overlap, some shapes may abut and/or some shapes have the right distance to layers of another aligned serial MOS layout instance to fulfill all design rules.

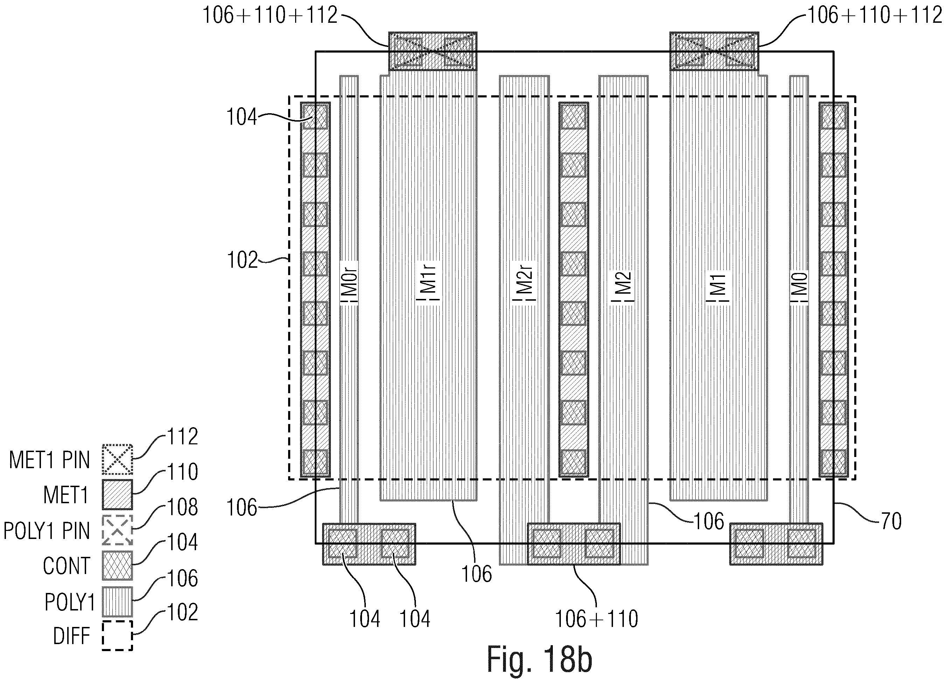

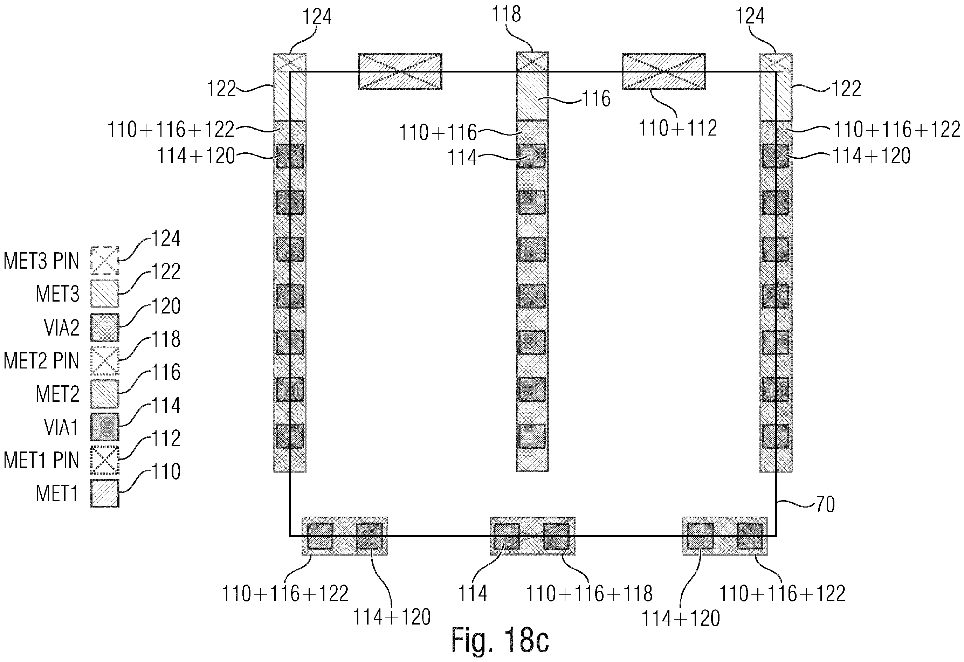

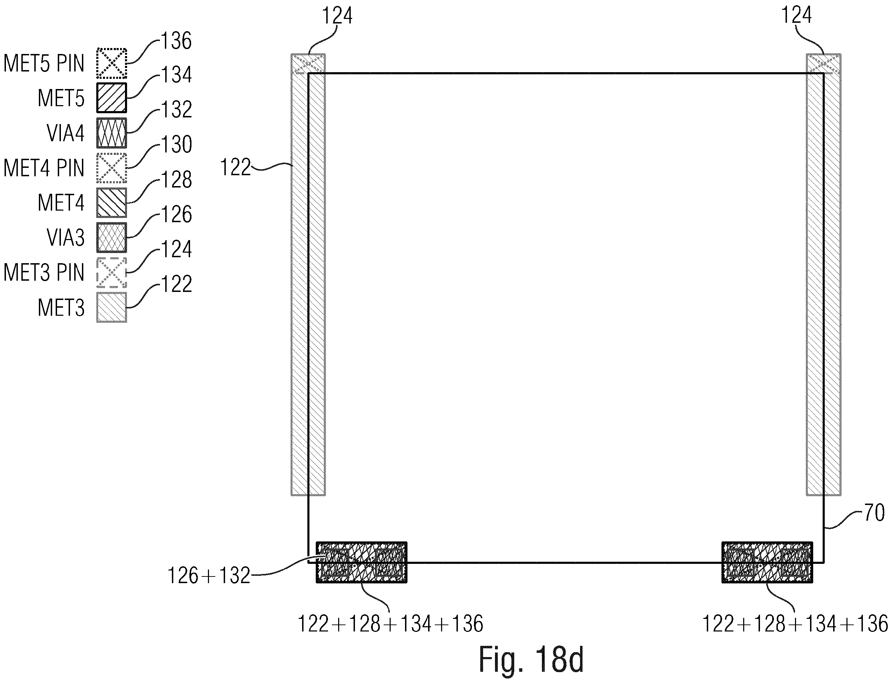

Furthermore, Fig. 18e shows an exploded view of the serial MOS element of Fig. 18, where the serial MOS element is shown in a top view. Thus, Fig. 18e reveals the different layer or level of the circuit layout. Besides the polysilicon layer 106 where the transistor finger are implemented and the diffusion layer 102 below, different metal layers and corresponding contacts are shown. In this example, 5 metal layers MET1 110, MET2 116, MET3 122, MET4 128, MET5 134 for contacting the transistor fingers are shown. Furthermore, for externally contacting the metal layers, respective contacts MET1 PIN 112, MET2 PIN 118, MET3 PIN 124, MET4 PIN 130, MET5 PIN 136 are illustrated. Vias VIA 1 114, VIA 2 120, VIA 3 126, VIA 4 132 are further formed to create internal connections between the metal layers. Additionally, contacts CONT 104 form the connection from MET1 to diffusion or polysilicon areas. Shapes needed to implement bulk contacts 60 are not drawn in this example. Since the layouts of Fig. 14, Fig. 16, Fig. 17 are formed using the serial MOS element of Fig. 18, reference signs and the legend may be correspondingly applied from Fig. 18a and Fig. 18e to Fig. 14, Fig. 16, and Fig. 17. Moreover, Fig. 18a shows the serial MOS element of Fig. 18e in a top view. Layers in Fig. 18a are partially transparent, such that typically, the topmost metallization layer, the topmost metallization pin, and the topmost via are shown where multiple layer are overlapping. Any other level or layer that may hidden in the top view of Fig. 18a may be identified in the exploded view of Fig. 18e or in the partial views of Fig. 18b to Fig. 18d.

These partial views comprise a subset of the total number of layers, wherein the subset of layers is choses such that each layer may be identified. Therefore, the subset of layers of Fig. 18b comprises the diffusion layer, the polysilicon layer, and the first metal layer with the respective contacts. The subset of layers of Fig. 18c comprises the first metal layer, the second metal layer, and the third metal layer with the respective contacts. The subset of layers of Fig. 18d comprises the third metal layer, the fourth metal layer and the fifth metal layer with the respective contacts.

The submodule (serial MOS element) corresponds to a series of MOS transistors going one column of the schematic array down and the next up (Fig. 19). That's how the circuit can be divided into three submodules. To enhance symmetry the module 4a leftmost in schematic is moved to the middle of the layout then. The layout arrangement becomes (output transistors of the current mirror denoted with the label B using serial MOS element 4a') - (input transistors of the current mirror denoted with the label A using serial MOS element 4a) - (output transistors of the current mirror denoted with the label B using serial MOS element 4a'). Thus, a patterned array (cf. Fig. 16) may be derived from the resulting pattern BBAABB. Fig. 19 sketches this in schematic and therefore illustrates how layout (cf. Fig. 16 and 17) rearranges MOS transistor's finger array order.

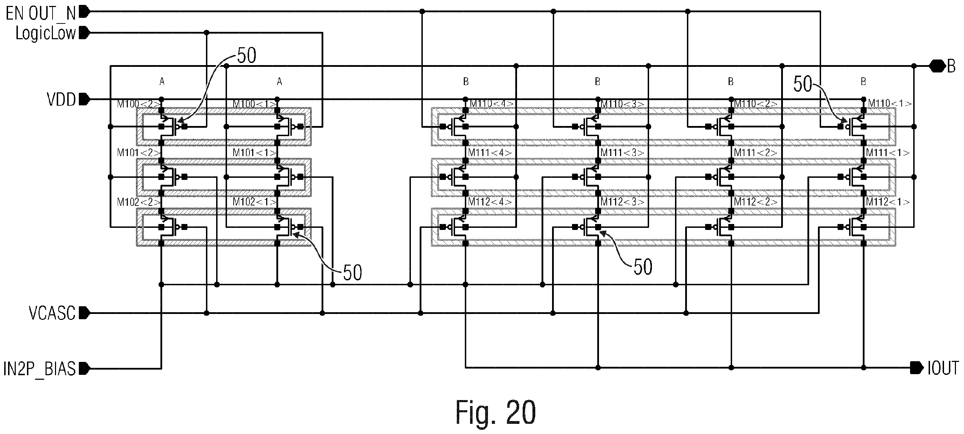

Fig. 20 shows how the traditionally sketched schematic Fig. 13 combines the elements of the MOS finger matrix. Obviously this does not correspond to the way how the elements are combined in the layout.

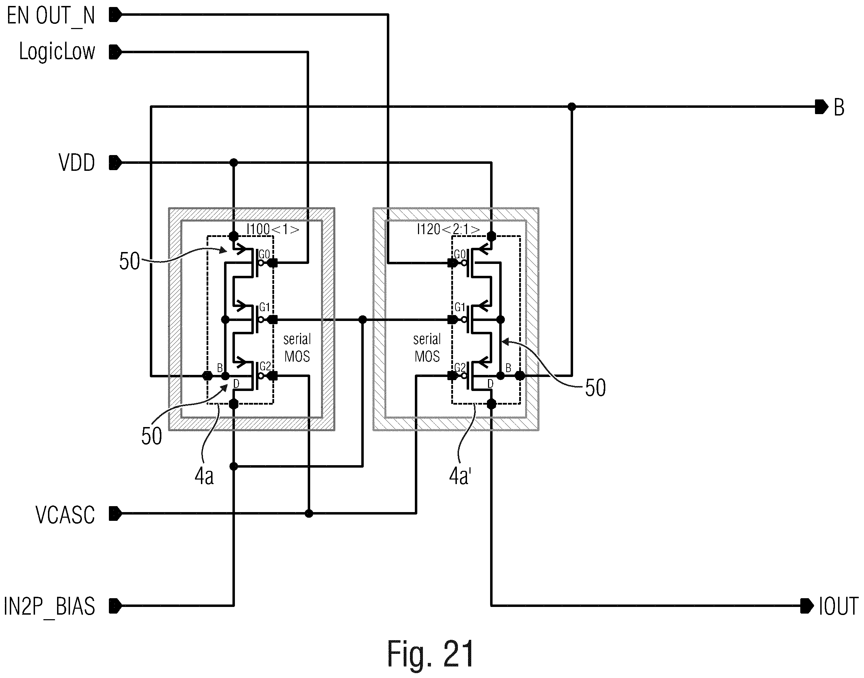

When the circuit is composed from serial MOS modules also in the schematic (shown in Fig. 21) the arrangement structure in the schematic will correspond to the structure in layout. Then the module contains three single instances from each MOS transistor finger array row as illustrated in Fig. 22. One instance I100<1> for the input path and two iterated instances I<2:1> for the output path. Moreover, it has to be noted that the schematics or circuit diagrams of Fig. 13, Fig. 15, Fig. 19, Fig. 20, and Fig. 21 all reveal the same circuit (switched current mirror). However, Fig. 13 and Fig. 21 show the switched mirror on module level wherein the remaining Fig. 15, Fig. 19, and Fig. 20 show the switched mirror circuit on transistor finger level. Additionally, Fig. 22 shows the serial MOS element used to form the switched mirror circuit in a schematic on transistor finger level.

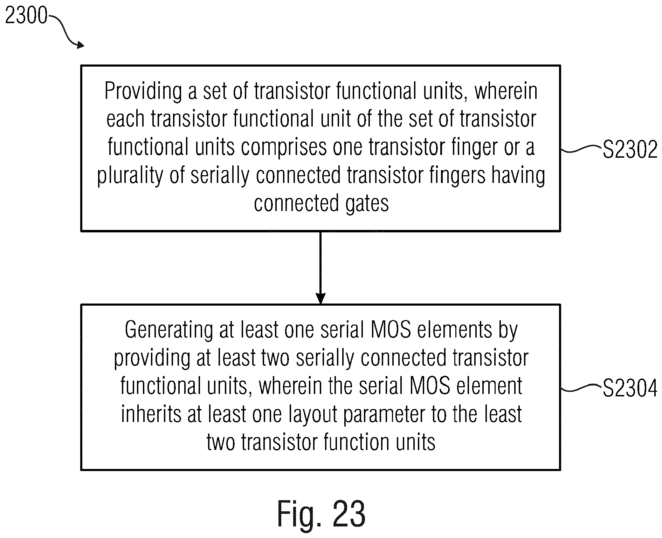

Fig. 23 shows a schematic block diagram of a method for generating serial MOS elements. The method 2300 comprises a step S2302 of providing a set of transistor functional units, wherein each transistor functional unit of the set of transistor functional units comprises one transistor finger or a plurality of serially connected transistor fingers having connected gates and a step S2304 of generating at least one serial MOS element by providing at least two serially connected transistor functional units, wherein the serial MOS element inherits at least one layout parameter to the at least two transistor functional units.

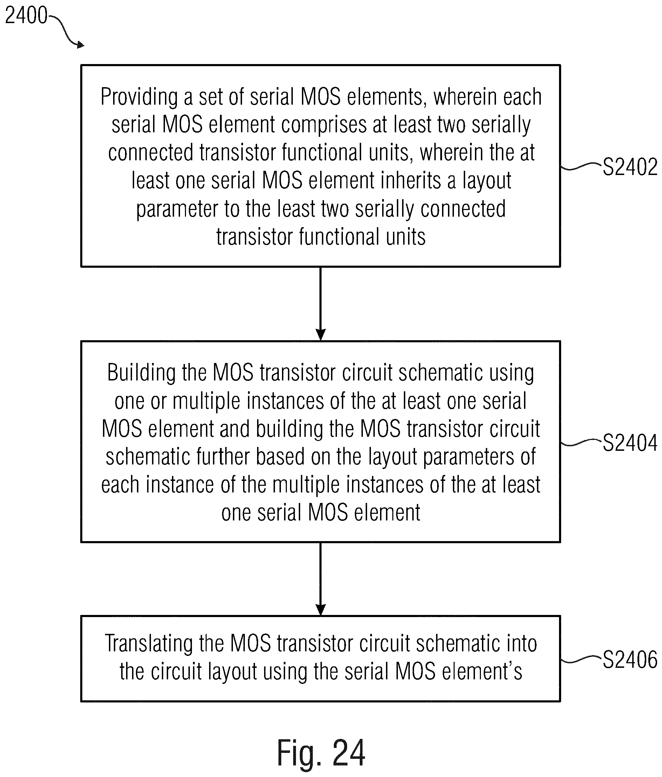

Fig. 24 shows a schematic block diagram of a method 2400 for building a circuit layout from a MOS transistor circuit schematic. The method comprises a step S2402 of providing a set of serial MOS elements, wherein each serial MOS element comprises at least two serially connected transistor functional units, wherein the at least one serial MOS element inherits a layout parameter to the at least two serially connected transistor functional units, a step S404 of building a MOS transistor circuit schematic using one or multiple instances of the at least one serial MOS element and building the MOS transistor circuit schematic further based on the layout parameters of each instance of the multiple instances of the at least one serial MOS element, and a step S2406 of translating the MOS transistor circuit schematic into the circuit layout using the serial MOS elements layouts.

It is to be understood that in this specification, the signals on lines are sometimes named by the reference numerals for the lines or are sometimes indicated by the reference numerals themselves, which have been attributed to the lines. Therefore, the notation is such that a line having a certain signal is indicating the signal itself. A line can be a physical line in a hardwired implementation. In a computerized implementation, however, a physical line does not exist, but the signal represented by the line is transmitted from one calculation module to the other calculation module. Moreover, it has to be noted that the apparatus 2 and/or the apparatus 22 may be at least partially coded in hardware.

Although the present invention has been described in the context of block diagrams where the blocks represent actual or logical hardware components, the present invention can also be implemented by a computer-implemented method. In the latter case, the blocks represent corresponding method steps where these steps stand for the functionalities performed by corresponding logical or physical hardware blocks.

Although some aspects have been described in the context of an apparatus, it is clear that these aspects also represent a description of the corresponding method, where a block or device corresponds to a method step or a feature of a method step. Analogously, aspects described in the context of a method step also represent a description of a corresponding block or item or feature of a corresponding apparatus. Some or all of the method steps may be executed by (or using) a hardware apparatus, like for example, a microprocessor, a programmable computer or an electronic circuit. In some embodiments, some one or more of the most important method steps may be executed by such an apparatus.

The inventive transmitted or encoded signal can be stored on a digital storage medium or can be transmitted on a transmission medium such as a wireless transmission medium or a wired transmission medium such as the Internet.

Depending on certain implementation requirements, embodiments of the invention can be implemented in hardware or in software. The implementation can be performed using a digital storage medium, for example a floppy disc, a DVD, a Blu-Ray, a CD, a ROM, a PROM, and EPROM, an EEPROM or a FLASH memory, having electronically readable control signals stored thereon, which cooperate (or are capable of cooperating) with a programmable computer system such that the respective method is performed. Therefore, the digital storage medium may be computer readable.

Some embodiments according to the invention comprise a data carrier having electronically readable control signals, which are capable of cooperating with a programmable computer system, such that one of the methods described herein is performed.

Generally, embodiments of the present invention can be implemented as a computer program product with a program code, the program code being operative for performing one of the methods when the computer program product runs on a computer. The program code may, for example, be stored on a machine readable carrier.

Other embodiments comprise the computer program for performing one of the methods described herein, stored on a machine readable carrier.

In other words, an embodiment of the inventive method is, therefore, a computer program having a program code for performing one of the methods described herein, when the computer program runs on a computer.

A further embodiment of the inventive method is, therefore, a data carrier (or a non-transitory storage medium such as a digital storage medium, or a computer-readable medium) comprising, recorded thereon, the computer program for performing one of the methods described herein. The data carrier, the digital storage medium or the recorded medium are typically tangible and/or non-transitory.

A further embodiment of the invention method is, therefore, a data stream or a sequence of signals representing the computer program for performing one of the methods described herein. The data stream or the sequence of signals may, for example, be configured to be transferred via a data communication connection, for example, via the internet.

A further embodiment comprises a processing means, for example, a computer or a programmable logic device, configured to, or adapted to, perform one of the methods described herein.

A further embodiment comprises a computer having installed thereon the computer program for performing one of the methods described herein.

A further embodiment according to the invention comprises an apparatus or a system configured to transfer (for example, electronically or optically) a computer program for performing one of the methods described herein to a receiver. The receiver may, for example, be a computer, a mobile device, a memory device or the like. The apparatus or system may, for example, comprise a file server for transferring the computer program to the receiver.

In some embodiments, a programmable logic device (for example, a field programmable gate array) may be used to perform some or all of the functionalities of the methods described herein. In some embodiments, a field programmable gate array may cooperate with a microprocessor in order to perform one of the methods described herein. Generally, the methods are preferably performed by any hardware apparatus.

The above described embodiments are merely illustrative for the principles of the present invention. It is understood that modifications and variations of the arrangements and the details described herein will be apparent to others skilled in the art. It is the intent, therefore, to be limited only by the scope of the impending patent claims and not by the specific details presented by way of description and explanation of the embodiments herein.

### Literature

[1] D.J. Chen and B.J. Sheu. Generalised approach to automatic custom layout of analogue ics. Circuits, Devices and Systems, IEE Proceedings G, 139(4):481-490, Aug 1992.
[2] T. Hirata, R. Nishino, S. Nakatake, M. Shimoyama, M. Miyagawa, K. Tanno and A. Yamada. Subblock-level matching layout for analog block-pair and its manufacturability evaluation. In Circuits and Systems (ISCAS), 2015 IEEE International Symposium on, pages 3012.3015, May 2015.
[3] R. Naiknaware and T.S. Fiez. Automated hierarchical cmos analog circuit stack generation with intramodule connectivity and matching considerations. Solid-state Circuits, IEEE Journal of, 34(3):304.303, March 1999.

## Claims

1. Apparatus (22) for performing a computer-implemented method for building a circuit layout (24) from a MOS transistor circuit schematic (26), the apparatus (22) comprising:
a serial MOS element provider (28) configured for providing a set of serial MOS elements (4, 4a, 4b), comprising:
a transistor functional unit provider (6) configured for providing a set of transistor functional units (10, 10a, 10b), wherein each transistor functional unit (10a, 10b) of the set of transistor functional units (10) comprises a representation of one transistor finger (50) having a gate area or of a plurality of serially connected transistor fingers having connected gate areas, wherein each transistor finger comprises a gate channel area with at least a drain area, a source area and the gate area; and
a serial MOS element generator (8) configured for generating at least one serial MOS element (4) having at least two serially connected transistor functional units (10), wherein the transistor functional units of the serial MOS element comprise the same gate width;
a circuit builder (30) configured for receiving the at least one serial MOS element (4) and for building the MOS transistor circuit schematic (26) using one or multiple instances of the at least one serial MOS element (4), wherein the circuit builder is further configured for building the MOS transistor circuit schematic (26) based on the layout parameters of each instance of the multiple instances of the at least one serial MOS element (4); and
a translator (32) for translating the MOS transistor circuit schematic (26) into the circuit layout (24) using the serial MOS element's layouts;
wherein the serial MOS element generator (8) is configured to generate the at least one serial MOS element (4) such that an instance of the at least one serial MOS element is directly abuttable to a further instance of each of the at least one serial MOS elements wherein directly abutted instances of serial MOS elements are electrically connected by forming joint diffusion areas by forming a joint doping area representing a drain or a source connection of the MOS transistor.

2. Apparatus (22) according to claim 1, wherein the serial MOS element generator (8) is configured for generating the at least one serial MOS element (4) comprising at least two gate areas, wherein the at least two gate areas are insulated from each other.

3. Apparatus (22) according to any of the preceding claims, wherein the serial MOS element generator (8) is configured to generate the at least two serially connected transistor functional units by directly abutting the drain or source areas (54, 56) of the serially connected transistor functional units.

4. Apparatus (22) according to any of the preceding claims, wherein the serial MOS element generator (8) is configured to generate the at least one serial MOS element (4) as a module or as a group of transistor functional units to allow generating multiple instances of the at least one serial MOS element, wherein the module or group comprises multiple identical serial MOS elements or different serial MOS elements with only small variations.

5. Apparatus (22) according to any of the preceding claims, wherein the serial MOS element generator (8) is configured to generate the at least one serial MOS element (4) from transistor functional units (10) having at least partially identical layout parameters.

6. Apparatus (22) according to any of the preceding claims, wherein the serial MOS element generator (8) is configured for generating the at least one serial MOS element (4) having a bulk contact as a layout parameter.

7. Apparatus according to any of the preceding claims, wherein the translator (32) is configured to translate serially connected serial MOS elements (4) from the MOS transistor circuit schematic (26) into directly abutted serial MOS elements in the circuit layout (24).

8. Apparatus (22) according to any of the preceding claims, wherein the circuit builder is configured to only use instances of the at least one serial MOS element (4) to generate the MOS transistor circuit schematic (26).

9. Apparatus (22) according to any of the preceding claims, wherein the circuit builder is configured for generating the transistor circuit schematic (26) using instances of exactly one serial MOS element (4).

10. Apparatus (22) according to any of the preceding claims, wherein the translator is configured to arrange a layout of the instances of the at least one serial MOS element such that the circuit layout (24) is arranged in a patterned array.

11. Apparatus (22) according to any of the preceding claims, wherein the translator (32) is configured to form wired connections between the pins of the multiple instances of the at least one serial MOS element and/or wherein the translator is configured to form connections using abutting of the multiple instances of the at least one serial MOS element according to the connections indicated in the MOS transistor circuit schematic (26).

12. Apparatus (22) according to any of the preceding claims, wherein the translator is configured to arrange bulk contacts (60) of a semiconductor substrate or well in the circuit layout.

13. Apparatus (22) according to any of the preceding claims, wherein the circuit builder (30) is configured to use the at least one serial MOS element as a module or as a group of transistor functional units.

14. Apparatus (22) according any of the preceding claims, wherein the circuit builder (30) is configured to restructure the transistor basic circuit (12) using the at least one serial MOS element (4) to generate the serial MOS transistor circuit schematic (26).

15. Computer-implemented method (2400) for building a circuit layout from a MOS transistor circuit schematic, the method comprising:
providing (S2302) a set of transistor functional units, wherein each transistor functional unit of the set of transistor functional units comprises a representation of one transistor finger having a gate area or of a plurality of serially connected transistor fingers having connected gates areas, wherein each transistor finger comprises a gate channel area with at least a drain area, a source area and the gate area; and generating (S2304) at least one serial MOS element having at least two serial connected transistor functional units such that an instance of the at least one serial MOS element is directly abuttable to a further instance of each of the at least one serial MOS elements, wherein directly abutted instances of serial MOS elements are electrically connected by forming joint diffusion areas by forming a joint doping area representing a drain or a source connection of the MOS transistor, wherein the transistor functional units of the serial MOS element comprise the same gate width;
receiving the at least one serial MOS element and building (S2404) the MOS transistor circuit schematic using one or multiple instances of the at least one serial MOS element and building the MOS transistor circuit schematic further based on the layout parameters of each instance of the multiple instances of the at least one serial MOS element; and
translating (S2406) the MOS transistor circuit schematic into the circuit layout using the serial MOS element's layouts.

## Patentansprüche

1. Vorrichtung (22) zum Ausführen eines computerimplementierten Verfahrens zum Aufbauen eines Schaltungslayouts (24) aus einem MOS-Transistorschaltungsschema (26), wobei die Vorrichtung (22) folgende Merkmale aufweist:
einen Serielles-MOS-Element-Bereitsteller (28), der konfiguriert ist zum Bereitstellen einer Menge von seriellen MOS-Elementen (4, 4a, 4b), wobei derselbe folgende Merkmale aufweist:
einen Transistorfunktionseinheitsbereitsteller (6), der konfiguriert ist zum Bereitstellen einer Menge von Transistorfunktionseinheiten (10, 10a, 10b), wobei jede Transistorfunktionseinheit (10a, 10b) der Menge von Transistorfunktionseinheiten (10) eine Darstellung von einem Transistorfinger (50) mit einem Gate-Bereich oder von einer Mehrzahl von in Reihe geschalteten Transistorfingern mit verbundenen Gate-Bereichen aufweist, wobei jeder Transistorfinger einen Gate-Kanalbereich mit zumindest einem Drain-Bereich, einem Source-Bereich und dem Gate-Bereich aufweist; und
einen Serielles-MOS-Element-Generator (8), der konfiguriert ist zum Erzeugen zumindest eines seriellen MOS-Elements (4) mit zumindest zwei in Reihe geschalteten Transistorfunktionseinheiten (10), wobei die Transistorfunktionseinheiten des seriellen MOS-Elements dieselbe Gate-Breite aufweisen;
einen Schaltungsbauer (30), der konfiguriert ist zum Empfangen des zumindest einen seriellen MOS-Elements (4) und zum Aufbauen des MOS-Transistorschaltungsschemas (26) unter Verwendung einer oder mehrerer Instanzen des zumindest einen seriellen MOS-Elements (4), wobei der Schaltungsbauer ferner konfiguriert ist zum Aufbauen des MOS-Transistorschaltungsschemas (26) auf der Basis der Layoutparameter jeder Instanz der mehreren Instanzen des zumindest einen seriellen MOS-Elements (4); und
einen Übersetzer (32) zum Übersetzen des MOS-Transistorschaltungsschemas (26) in das Schaltungslayout (24) unter Verwendung der Layouts des seriellen MOS-Elements;
wobei der Serielles-MOS-Element-Generator (8) dazu konfiguriert ist, das zumindest eine serielle MOS-Element (4) derart zu erzeugen, dass eine Instanz des zumindest einen seriellen MOS-Elements direkt an eine weitere Instanz jedes des zumindest einen seriellen MOS-Elements angrenzbar ist, wobei direkt angrenzende Instanzen von seriellen MOS-Elementen elektrisch verbunden sind durch Bilden gemeinsamer Diffusionsbereiche, indem ein gemeinsamer Dotierbereich gebildet wird, der eine Drain- oder eine Source-Verbindung des MOS-Transistors darstellt.

2. Vorrichtung (22) gemäß Anspruch 1, wobei der Serielles-MOS-Element-Generator (8) konfiguriert ist zum Erzeugen des zumindest einen seriellen MOS-Elements (4), das zumindest zwei Gate-Bereiche aufweist, wobei die zumindest zwei Gate-Bereiche voneinander isoliert sind.

3. Vorrichtung (22) gemäß einem der vorhergehenden Ansprüche, wobei der Serielles-MOS-Element-Generator (8) dazu konfiguriert ist, die zumindest zwei in Reihe geschalteten Transistorfunktionseinheiten durch direktes Angrenzen der Drain- oder Source-Bereiche (54, 56) der in Reihe geschalteten Transistorfunktionseinheiten zu erzeugen.

4. Vorrichtung (22) gemäß einem der vorhergehenden Ansprüche, wobei der Serielles-MOS-Element-Generator (8) ferner dazu konfiguriert ist, das zumindest eine seriellen MOS-Element (4) als ein Modul oder als eine Gruppe von Transistorfunktionseinheiten zu erzeugen, um eine Erzeugung mehrerer Instanzen des zumindest einen seriellen MOS-Elements zu ermöglichen, wobei das Modul oder die Gruppe mehrere identische serielle MOS-Elemente oder unterschiedliche serielle MOS-Elemente mit lediglich kleinen Variationen aufweist.

5. Vorrichtung (22) gemäß einem der vorhergehenden Ansprüche, wobei der Serielles-MOS-Element-Generator (8) dazu konfiguriert ist, das zumindest eine serielle MOS-Element (4) aus Transistorfunktionseinheiten (10) mit zumindest teilweise identischen Layoutparametern zu erzeugen.

6. Vorrichtung (22) gemäß einem der vorhergehenden Ansprüche, wobei der Serielles-MOS-Element-Generator (8) konfiguriert ist zum Erzeugen des zumindest einen seriellen MOS-Elements (4) mit einem Bulk-Kontakt als einen Layoutparameter.

7. Vorrichtung gemäß einem der vorhergehenden Ansprüche, wobei der Übersetzer (32) dazu konfiguriert ist, in Reihe geschaltete seriellen MOS-Elemente (4) aus dem MOS-Transistorschaltungsschema (26) in direkt angrenzende serielle MOS-Elemente in der Schaltungslayout (24) zu übersetzen.

8. Vorrichtung (22) gemäß einem der vorhergehenden Ansprüche, wobei der Schaltungsbauer dazu konfiguriert ist, lediglich Instanzen des zumindest einen seriellen MOS-Elements (4) zu verwenden, um das MOS-Transistorschaltungsschema (26) zu erzeugen.

9. Vorrichtung (22) gemäß einem der vorhergehenden Ansprüche, wobei der Schaltungsbauer konfiguriert ist zum Erzeugen des Transistor-Schaltung-Schemas (26) unter Verwendung von Instanzen von genau einem seriellen MOS-Element (4).

10. Vorrichtung (22) gemäß einem der vorhergehenden Ansprüche, wobei der Übersetzer dazu konfiguriert ist, ein Layout der Instanzen des zumindest einen seriellen MOS-Elements derart anzuordnen, dass das Schaltungslayout (24) in einem strukturierten Array angeordnet ist.

11. Vorrichtung (22) gemäß einem der vorhergehenden Ansprüche, wobei der Übersetzer (32) dazu konfiguriert ist, verdrahtete Verbindungen zwischen den Anschlussstiften der mehreren Instanzen des zumindest einen seriellen MOS-Elements zu bilden, und/oder wobei der Übersetzer dazu konfiguriert ist, Verbindungen unter Verwendung einer Angrenzung der mehreren Instanzen des zumindest einen seriellen MOS-Elements gemäß den in dem MOS-Transistorschaltungsschema (26) angegebenen Verbindungen zu bilden.

12. Vorrichtung (22) gemäß einem der vorhergehenden Ansprüche, wobei der Übersetzer dazu konfiguriert ist, Bulk-Kontakte (60) eines Halbleitersubstrats oder -topfes in dem Schaltungslayout anzuordnen.

13. Vorrichtung (22) gemäß einem der vorhergehenden Ansprüche, wobei der Schaltungsbauer (30) dazu konfiguriert ist, das zumindest eine serielle MOS-Element als ein Modul oder als eine Gruppe von Transistorfunktionseinheiten zu verwenden.

14. Vorrichtung (22) gemäß einem der vorhergehenden Ansprüche, wobei der Schaltungsbauer (30) dazu konfiguriert ist, die Transistorbasisschaltung (12) unter Verwendung des zumindest einen seriellen MOS-Elements (4) neu zu strukturieren, um das Serielles-MOS-Transistorschaltungsschema (26) zu erzeugen.

15. Computer-implementiertes Verfahren zum Aufbauen eines Schaltungslayouts aus einem MOS-Transistorschaltungsschema, wobei das Verfahren folgende Schritte aufweist:
Bereitstellen (S2302) einer Menge von Transistorfunktionseinheiten, wobei jede Transistorfunktionseinheit der Menge von Transistorfunktionseinheiten eine Darstellung von einem Transistorfinger mit einem Gate-Bereich oder von einer Mehrzahl von in Reihe geschalteten Transistorfingern mit verbundenen Gate-Bereichen aufweist, wobei jeder Transistorfinger einen Gate-Kanalbereich mit zumindest einem Drain-Bereich, einem Source-Bereich und dem Gate-Bereich aufweist; und
Erzeugen (S2304) zumindest eines seriellen MOS-Elements mit zumindest zwei in Reihe geschalteten Transistorfunktionseinheiten derart, dass eine Instanz des zumindest einen seriellen MOS-Elements direkt an eine weitere Instanz jedes des zumindest einen seriellen MOS-Elements angrenzbar ist, wobei direkt angrenzende Instanzen von seriellen MOS-Elementen elektrisch verbunden werden durch Bilden gemeinsamer Diffusionsbereiche, indem ein gemeinsamer Dotierbereich gebildet wird, der eine Drain- oder eine Source-Verbindung des MOS-Transistors darstellt, wobei die Transistorfunktionseinheiten des seriellen MOS-Elements dieselbe Gate-Breite aufweisen;
Empfangen des zumindest einen seriellen MOS-Elements und Aufbauen (S404) des MOS-Transistorschaltungsschemas unter Verwendung einer oder mehrerer Instanzen des zumindest einen seriellen MOS-Elements, und Aufbauen des MOS-Transistorschaltungsschemas ferner auf der Basis der Layoutparameter jeder Instanz der mehreren Instanzen des zumindest einen seriellen MOS-Elements; und Übersetzen (S2406) des MOS-Transistorschaltungsschemas in das Schaltungslayout unter Verwendung der Layouts des seriellen MOS-Elements.

## Revendications

1. Appareil (22) pour réaliser un procédé mis en oeuvre par ordinateur pour construire un aménagement de circuits (24) à partir d'un schéma de circuit de transistor MOS (26), l'appareil (22) comprenant:
un fournisseur d'éléments MOS en série (28) configuré pour fournir un ensemble d'éléments MOS en série (4, 4a, 4b), comprenant:
un fournisseur d'unités fonctionnelles de transistor (6) configuré pour fournir un ensemble d'unités fonctionnelles de transistor (10, 10a, 10b), où chaque unité fonctionnelle de transistor (10a, 10b) de l'ensemble d'unités fonctionnelles de transistor (10) comprend une représentation d'un doigt de transistor (50) présentant une zone de grille ou d'une pluralité de doigts de transistor connectés en série présentant des zones de grille connectées, où chaque doigt de transistor comprend une zone de canal de grille avec au moins une zone de drain, une zone de source et la zone de grille; et
un générateur d'éléments MOS en série (8) configuré pour générer au moins un élément MOS en série (4) présentant au moins deux unités fonctionnelles de transistor connectées en série (10), où les unités fonctionnelles de transistor de l'élément MOS en série comprennent la même largeur de grille;
un constructeur de circuit (30) configuré pour recevoir les au moins un élément MOS en série (4) et pour construire le schéma de circuit de transistor MOS (26) à l'aide d'une ou de multiples occurrences des au moins un élément MOS en série (4), où le constructeur de circuit est par ailleurs configuré pour construire le schéma de circuit de transistor MOS (26) sur base des paramètres de configuration de chaque occurrence parmi les multiples occurrences des au moins un élément MOS en série (4); et
un moyen de translation (32) destiné à déplacer en translation le schéma de circuit du transistor MOS (26) vers l'aménagement de circuits (24) à l'aide des configurations de l'élément MOS en série;
dans lequel le générateur d'éléments MOS en série (8) est configuré pour générer les au moins un élément MOS en série (4) de sorte qu'une occurrence des au moins un élément MOS en série puisse venir directement en butée contre une autre occurrence de chacun des au moins un élément MOS en série, où les occurrences d'éléments MOS venant directement en butée sont connectées électriquement en formant des zones de diffusion communes en formant une zone de dopage commune représentant une connexion de drain ou de source du transistor MOS.

2. Appareil (22) selon la revendication 1, dans lequel le générateur d'éléments MOS en série (8) est configuré pour générer les au moins un élément MOS en série (4) comprenant au moins deux zones de grille, dans lequel lesdites au moins deux zones de grille sont isolées l'une de l'autre.

3. Appareil (22) selon l'une quelconque des revendications précédentes, dans lequel le générateur d'éléments MOS en série (8) est configuré pour générer les au moins deux unités fonctionnelles de transistor connectées en série en amenant directement en butée les zones de drain ou de source (54, 56) des unités fonctionnelles de transistor connectées en série.

4. Appareil (22) selon l'une quelconque des revendications précédentes, dans lequel le générateur d'éléments MOS en série (8) est configuré pour générer les au moins un élément MOS en série (4) comme module ou comme groupe d'unités fonctionnelles de transistor pour permettre de générer de multiples occurrences des au moins un élément MOS en série, dans lequel le module ou le groupe comprend plusieurs éléments MOS en série identiques ou différents éléments MOS en série avec uniquement des faibles variations.

5. Appareil (22) selon l'une quelconque des revendications précédentes, dans lequel le générateur d'éléments MOS en série (8) est configuré pour générer les au moins un élément MOS en série (4) à partir d'unités fonctionnelles de transistor (10) présentant des paramètres de configuration au moins partiellement identiques.

6. Appareil (22) selon l'une quelconque des revendications précédentes, dans lequel le générateur d'éléments MOS en série (8) est configuré pour générer les au moins un élément MOS en série (4) présentant un contact de masse comme paramètre de configuration.

7. Appareil selon l'une quelconque des revendications précédentes, dans lequel le moyen de translation (32) est configuré pour déplacer en translation les éléments MOS en série connectés en série (4) du schéma de circuit de transistor MOS (26) vers les éléments MOS en série venant directement en butée dans l'aménagement de circuits (24).

8. Appareil (22) selon l'une quelconque des revendications précédentes, dans lequel le constructeur de circuit est configuré pour utiliser uniquement les occurrences des au moins un élément MOS en série (4) pour générer le schéma de circuit de transistor MOS (26).

9. Appareil (22) selon l'une quelconque des revendications précédentes, dans lequel le constructeur de circuit est configuré pour générer le schéma de circuit de transistor (26) à l'aide des occurrences d'exactement un élément MOS en série (4).

10. Appareil (22) selon l'une quelconque des revendications précédentes, dans lequel le moyen de translation est configuré pour disposer un aménagement des occurrences des au moins un élément MOS en série de sorte que l'aménagement de circuits (24) soit disposé selon un réseau de modèles.

11. Appareil (22) selon l'une quelconque des revendications précédentes, dans lequel le moyen de translation (32) est configuré pour former des connexions filaires entre les broches des multiples occurrences des au moins un élément MOS en série et/ou dans lequel le moyen de translation est configuré pour former des connexions à l'aide de la venue en butée des multiples occurrences des au moins un élément MOS en série selon les connexions indiquées dans le schéma de circuit de transistor MOS (26).

12. Appareil (22) selon l'une quelconque des revendications précédentes, dans lequel le moyen de translation est configuré pour disposer les contacts de masse (60) d'un substrat semi-conducteur ou d'un puits dans l'aménagement de circuits.

13. Appareil (22) selon l'une quelconque des revendications précédentes, dans lequel le constructeur de circuit (30) est configuré pour utiliser les au moins un élément MOS en série comme module ou comme groupe d'unités fonctionnelles de transistor.

14. Appareil (22) selon l'une quelconque des revendications précédentes, dans lequel le constructeur de circuit (30) est configuré pour restructurer le circuit de base de transistor (12) à l'aide des au moins un élément MOS en série (4) pour générer le schéma de circuit de transistor MOS en série (26).

15. Procédé mis en oeuvre par ordinateur (2400) pour construire un aménagement de circuits à partir d'un schéma de circuit de transistor MOS, le procédé comprenant le fait de:
prévoir (S2302) un ensemble d'unités fonctionnelles de transistor, où chaque unité fonctionnelle de transistor de l'ensemble d'unités fonctionnelles de transistor comprend une représentation d'un doigt de transistor présentant une zone de grille ou d'une pluralité de doigts de transistor connectés en série présentant des zones de grilles connectées, où chaque doigt de transistor comprend une zone de canal de grille avec au moins une zone de drain, une zone de source et la zone de grille; et
générer (S2304) au moins un élément MOS en série présentant au moins deux unités fonctionnelles de transistor connectées en série de sorte qu'une occurrence des au moins un élément MOS en série puisse être directement amenée en butée contre une autre occurrence de chacun des au moins un élément MOS en série, où les occurrences amenées directement en butée des éléments MOS en série sont connectées électriquement en formant des zones de diffusion communes en formant une zone de dopage commune représentant une connexion de drain ou de source du transistor MOS, où les unités fonctionnelles de transistor de l'élément MOS en série comprennent la même largeur de grille;
recevoir les au moins un élément MOS en série et construire (S2404) le schéma de circuit de transistor MOS à l'aide d'une ou de plusieurs occurrences des au moins un élément MOS en série et construire le schéma de circuit de transistor MOS sur base par ailleurs des paramètres de configuration de chaque occurrence des multiples occurrences des au moins un élément MOS en série; et
déplacer en translation (S2406) le schéma de circuit de transistor MOS vers l'aménagement de circuits à l'aide des aménagements de l'élément MOS en série.
